(19) **Europäisches Patentamt**
**European Patent Office**
**Office européen des brevets**

(11) **EP 2 439 551 A1**

(12) **EUROPÄISCHE PATENTANMELDUNG**

(43) Veröffentlichungstag:
**11.04.2012   Patentblatt 2012/15**

(51) Int Cl.:
*G01R 31/36* (2006.01)     *H02J 7/00* (2006.01)
*B60L 11/18* (2006.01)

(21) Anmeldenummer: **10186547.5**

(22) Anmeldetag: **05.10.2010**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**

(71) Anmelder: **IPS Integrated Power Solutions AG
2562 Port b. Biel (CH)**

(72) Erfinder:
• **Vezzini, Andrea
3274 Merzligen (CH)**
• **Christ, Markus
2505 Biel (CH)**

(74) Vertreter: **Cohausz & Florack
Patent- und Rechtsanwälte
Partnerschaftsgesellschaft
Bleichstraße 14
40211 Düsseldorf (DE)**

(54) **Verfahren zur Ermittlung von Batteriezustandsinformationen**

(57)   Die vorliegende Erfindung betrifft das Erfassen mindestens eines Parameters für mindestens eine Batteriezelle (160) einer Vielzahl von Batteriezellen während eines Lade- oder Entladevorgangs, wobei die Vielzahl von Batteriezellen zur Versorgung eines Elektrofahrzeuges eingerichtet sind und der mindestens eine Parameter mindestens einen der Parameter Spannung, Strom und Temperatur umfasst; das Ermitteln von Batteriezustandsinformationen für mindestens eine Batteriezelle der Vielzahl von Batteriezellen auf Grundlage des erfassten mindestens einen Parameters; und das Speichern der Batteriezustandsinformationen.

Fig.1c

EP 2 439 551 A1

**Beschreibung**

Die vorliegende Erfindung betrifft ein Verfahren, eine Vorrichtung und ein System zum Ermitteln von Batteriezustandsinformationen für mindestens eine Batteriezelle einer Vielzahl von Batteriezellen.

Batteriezellen, wie beispielsweise elektrochemische Batteriezellen, z.B. Lithium-Ionen Batteriezellen, werden häufig bei mobilen elektrischen Verbrauchern eingesetzt, wobei eine Vielzahl von solchen Batteriezellen beispielsweise in einem Batteriepack zum Betreiben des jeweiligen mobilen elektrischen Verbrauchers angeordnet sein könne.

Es ist bekannt, dass das Betreiben solch einer Vielzahl von Batteriezellen, sowohl bei einem Ladevorgang als auch bei einem Entladevorgang, d.h. beim Betrieb des jeweiligen mobilen elektrischen Verbrauchers, aufgrund der Vielzahl der Batteriezellen besondere Ansprüche an das Betreiben der einzelnen Batteriezellen der Vielzahl von Batteriezellen stellt. So muss beispielsweise bei einem Ladevorgang sicher gestellt werden, dass keine der Batteriezellen überlastet wird, gleichzeitig soll jedoch eine möglichst gute Aufladung sämtlicher Batteriezellen gewährleistet werden. Umgekehrt ist bei einem Entladevorgang zu beachten, dass keine der Batteriezellen in einem Betriebszustand betrieben wird, der eine Schädigung der Batteriezelle nach sich führen kann.

Die zuvor hergeleitete und aus dem Stand der Technik aufgezeigte Aufgabe wird gemäß einem Verfahren, umfassend das Erfassen mindestens eines Parameters für mindestens eine Batteriezelle einer Vielzahl von Batteriezellen während eines Lade- oder Entladevorgangs, wobei die Vielzahl von Batteriezellen zur Versorgung eines Elektrofahrzeuges eingerichtet sind und der mindestens eine Parameter mindestens einen der Parameter Spannung, Strom und Temperatur umfasst, und wobei das Verfahren das Ermitteln von Batteriezustandsinformationen für mindestens eine Batteriezelle der Vielzahl von Batteriezellen auf Grundlage des erfassten mindestens einen Parameters umfasst, und wobei das Verfahren das Speichern mindestens einer der Batteriezustandsinformationen umfasst.

Diese Aufgabe wird ferner gelöst durch eine Steuervorrichtung, welche dazu eingerichtet ist, mindestens einen Parameter für mindestens eine Batteriezelle einer Vielzahl von Batteriezellen während eines Lade- oder Entladevorgangs zu erfassen, wobei die Vielzahl von Batteriezellen zur Versorgung eines Elektrofahrzeuges eingerichtet sind und der mindestens eine Parameter mindestens einen der Parameter Spannung, Strom und Temperatur umfasst; und wobei die Steuervorrichtung dazu eingerichtet ist, Batteriezustandsinformationen für mindestens eine Batteriezelle der Vielzahl von Batteriezellen auf Grundlage des erfassten mindestens einen Parameters zu ermitteln und mindestens eine der Batteriezustandsinformationen zu speichern.

Diese Aufgabe wird ferner gelöst durch eine Vorrichtung, umfassend: Mittel zum Erfassen mindestens eines Parameters für mindestens eine Batteriezelle einer Vielzahl von Batteriezellen während eines Lade- oder Entladevorgangs, wobei die Vielzahl von Batteriezellen zur Versorgung eines Elektrofahrzeuges eingerichtet sind und der mindestens eine Parameter mindestens einen der Parameter Spannung, Strom und Temperatur umfasst; Mittel zum Ermitteln von Batteriezustandsinformationen für mindestens eine Batteriezelle der Vielzahl von Batteriezellen auf Grundlage des erfassten mindestens einen Parameters; und Mittel zum Speichern der Batteriezustandsinformationen

Diese Aufgabe wird ferner gelöst durch ein System umfassend die zuvor genannte Vorrichtung und eine Vielzahl von Batteriezellen, die mit dieser Vorrichtung verbunden sind, sodass die Steuervorrichtung den mindestens einen Parameter für mindestens eine Batteriezelle der Vielzahl von Batteriezellen erfassen kann.

Diese Aufgabe wird ferner gelöst durch ein Computerprogramm, welches das zuvor genannte Verfahren ausführt.

Beispielsweise kann mindestens ein Parameter genau jeweils einer Batteriezelle der Vielzahl von Batteriezellen zugeordnet sein, es kann aber auch mindestens ein Parameter jeweils einer Mehrzahl von Batteriezellen der Vielzahl von Batteriezellen zugeordnet sein.

Die Batteriezellen können beispielsweise elektrochemische Batteriezellen darstellen, wie beispielsweise Akkumulatorbatteriezellen, insbesondere Bleiakkumulatorbatteriezellen oder Lithium-Ionen-Akkumulatorbatteriezellen oder dergleichen. Diese Batteriezellen können beispielsweise in einem Batteriepack für Elektrofahrzeuge, insbesondere Flurförderzeuge, angeordnet sein. Die Elektrofahrzeuge können beispielsweise Hybridkraftfahrzeuge, elektrisch betriebene Fahrzeuge wie beispielsweise Flurförderzeuge, elektrische Fahrräder, elektrische Rollstühle oder dergleichen darstellen.

Beispielsweise kann mindestens einer Batteriezelle der Vielzahl von Batteriezellen ein Sensormittel zugeordnet sein, wobei das jeweilige Sensormittel einer Batteriezelle dazu eingerichtet sein kann, mindestens einen Parameter dieser jeweiligen Batteriezelle zu ermitteln und an die Steuervorrichtung zu kommunizieren. Beispielsweise kann ein Sensormittel zwei Kontakte zum Abgreifen der Spannung der jeweiligen Batteriezelle aufweisen und/oder einen Temperatursensor zur Ermittlung der Temperatur der jeweiligen Batteriezelle aufweisen. Darüber hinaus kann das Sensormittel beispielsweise auch Mittel zum Detektieren eines Stroms, welcher durch die jeweilige Batteriezelle fließt, umfassen.

Die Mittel zum Erfassen mindestens eines Parameters kann beispielsweise eine Schnittstelle der Vorrichtung sein, welche dazu eingerichtet ist, mit einer Schnittstelle der jeweiligen Sensormittel zu kommunizieren.

So können die Sensormittel jeweils eine Schnittstelle aufweisen, welche dazu eingerichtet ist, mit einer Schnittstelle der Vorrichtung verbunden zu werden. Somit kann die Vorrichtung die jeweiligen Parameter von mindestens einer Batteriezelle der Vielzahl von Batteriezellen von den jeweiligen Sensormitteln erfassen.

Beispielsweise kann jedes der Sensormittel auch Speichermittel zur Speicherung von Daten aufweisen. So können beispielsweise in den Speichermitteln erfasste Parameter, wie z.B. Spannung und/oder Temperatur und/oder Strom zwischengespeichert werden, und beispielsweise auf Anforderung von der Vorrichtung an die Vorrichtung übertragen werden. Beispielsweise kann auch jeder Batteriezelle der Vielzahl von Batteriezellen jeweils ein eindeutiger Identifikator zugeordnet sein, welcher beispielsweise als Parameter in den Speichermitteln der Sensormittel eingespeichert werden können. Somit kann die Vorrichtung den eindeutigen Identifikator der jeweiligen Batteriezelle, welche den jeweiligen Sensormittel zugeordnet ist, auslesen, und somit die weiteren von diesem Sensormittel empfangenen Parameter eindeutig einer Batteriezelle zuordnen.

Die Vorrichtung kann beispielsweise eine Verarbeitungseinheit, wie beispielsweise einen Mikroprozessor aufweisen, welcher die Mittel zum Ermitteln von Batteriezustandsinformationen umfasst. Dieser Mikroprozessor kann dazu eingerichtet sein, von außerhalb programmiert zu werden. Die Verarbeitungseinheit kann aber auch eine integrierte Schaltung mit fester Verdrahtung sein, oder ein FPGA, DSP oder dergleichen.

Die Vorrichtung kann dazu eingerichtet sein, auf Grundlage der ermittelten Batteriezustandsinformationen beispielsweise einen Ladevorgang und/oder einen Entladevorgang der Vielzahl von Batteriezellen zu steuern bzw. zu regeln. Desweiteren kann die Vorrichtung dazu eingerichtet sein, Information über die erfassten Parameter und/oder die ermittelten Batteriezustandsinformationen an einem Ausgabemittel auszugeben. Die Ausgabe der Information durch diese Ausgabemittel kann beispielsweise optisch und/oder akustisch erfolgen.

Die ermittelten Batteriezustandsinformationen können beispielsweise mindestens eine der folgenden Informationen umfassen: Die Reihenfolge, in welcher die Batteriezellen während eines Ladevorgangs die jeweils eine vordefinierte Spannung erreichen; Zeitinformationen über den Zeitpunkt, zu welchem die jeweilige Batteriezelle eine vordefinierte Spannung während eines Ladevorgangs erreicht; Information über den Ladezustand einer jeweiligen Batteriezelle; Information über einen kritischen Zustand einer jeweiligen Batteriezelle; und Information über die Anzahl der Ladeund/oder Entladezyklen der jeweiligen Batteriezelle.

Auch die Verwendung dieser nicht abschließend aufgezählten Batteriezustandsinformationen wird im Folgenden genauer eingegangen.

Eine Ausgestaltung der Erfindung sieht vor, dass überprüft wird, ob ein kritischer Zustand mindestens einer Batteriezelle vorliegt, wobei dieser kritische Zustand einer Batteriezelle der Vielzahl von Batteriezellen beispielsweise auf Grundlage des mindestens einen erfassten Parameters mindestens einer Batteriezelle und/oder der ermittelten Batteriezustandsinformation von mindestens einer Batteriezelle festgestellt werden kann.

Wird beispielsweise ein kritischer Zustand von mindestens einer Batteriezelle der Vielzahl von Batteriezellen festgestellt, so kann beispielsweise die Vorrichtung eine bestimmte Funktion zur Beeinflussung eines Lade- oder Entladestroms für die mindestens eine Batteriezelle der Vielzahl von Batteriezellen auslösen. Diese Funktion kann beispielsweise das Absenken eines Ladestroms für diese mindestens eine Batteriezelle der Vielzahl von Batteriezellen umfassen, sie kann das Trennen dieser mindestens einen Batteriezelle von einem Ladegerät oder einem elektrischen Verbraucher durch einen Leistungsschalter umfassen, wobei dieses Trennen durch einen Leistungsschalter auch das Trennen durch einen Hauptleistungsschalter, welcher sämtliche Batteriezellen der Vielzahl von Batteriezellen von einem Ladegerät bzw. einem elektrischen Verbraucher trennt, umfassen. Diese Funktion kann auch noch weitere Funktionen umfassen, wie im Nachfolgenden erläutert wird.

Beispielsweise kann in der Überprüfung, ob ein kritischer Zustand mindestens einer Batteriezelle vorliegt, eine Überprüfung vorgenommen werden, ob die Temperatur mindestes einer Batteriezelle einen vordefinierten oberen und/oder einen vordefinierten unteren Grenzwert über bzw. unterschreitet, umfassen. So kann beispielsweise, wenn die Temperatur einer Batteriezelle den vordefinierten oberen Grenzwert überschreitet die Funktion der Ansteuerung einer dieser jeweiligen Batteriezelle zugeordneten Klimatisierungsvorrichtung umfassen, sodass diese Batteriezelle durch die aktivierte Klimatisierungsvorrichtung gekühlt wird. Darüber hinaus kann beispielsweise auch ein Ladestrom für diese Batteriezelle abgesenkt werden, wenn der erfasste Temperaturwert dieser Batteriezelle den vordefinierten oberen Grenzwert überschreitet. Gleichermaßen kann der Ladestrom für diese Batteriezelle abgesenkt werden, wenn der vordefinierte untere Grenzwert für eine Temperatur unterschritten wird.

Eine Ausgestaltung der Erfindung sieht vor, dass die Vorrichtung dazu eingerichtet ist, eine Information über den Ladezustand jeder beliebigen Batteriezelle auf Grundlage der erfassten Parameter zu ermitteln. Die Information über den Ladezustand über jede beliebige Batteriezelle kann beispielsweise von der Vorrichtung durch die Ausgabemittel ausgegeben werden, und/oder sie kann zur Steuerung eines Lade- und/oder Entladevorgangs der Vielzahl von Batteriezellen verwendet werden.

Eine Ausgestaltung der Erfindung sieht vor, dass die Information über den Ladezustand einer jeweiligen Batteriezelle der Vielzahl von Batteriezellen mindestens einen der folgenden Werte umfasst:

Absoluter Ladezustand, normierter Ladezustand, und ein auf einen eingeschränkten Kapazitätsbereich abgebildeter Ladezustand.

Der absolute Ladezustand für eine Batteriezelle kann beispielsweise durch Integration des Stroms der jeweiligen Batteriezelle ermittelt werden, d.h., der absolute Ladezustand kann ein Maß für die aufgenommene Ladung der jeweiligen Batteriezelle darstellen. Beispielsweise kann der absolute Ladezustand in Amperestunden (Ah) angegeben werden. Dieser durch Integration des Stroms ermittelte absolute Ladezustand wird im Folgenden als absoluter, unkorrigierter Ladezustand bezeichnet. Bei einem positiven Strom durch eine Batteriezelle, d.h. bei einem Ladevorgang nimmt der absolute, unkorrigierte Ladezustand zu, während bei einem negativen Storm durch diese Batteriezelle, d.h. bei einem Entladevorgang, nimmt der absolute, unkorrigierte Ladezustand ab.

Der absolute Ladezustand kann auch ein absoluter, korrigierter Ladezustand sein, welcher beispielsweise zusätzlich zum absoluten unkorrigierten Ladezustand ermittelt wird, und welcher sich vom absoluten, unkorrigierten Ladezustand darin unterscheidet, dass zusätzlich die Reduktion der zur Verfügung stehenden Ladungsmenge (Ah) in Funktion des Ladestroms und/oder der Temperatur berücksichtigt wird. Hierzu können beispielsweise Korrekturfaktoren bestimmt werden und die pro Zeiteinheit entnommene bzw. zugeführte Ladungsmenge kann entsprechend korrigiert werden. Diese Korrekturfaktoren können beispielsweise auf Grundlage von Messungen und/oder theoretischen Modellen für jeden Batteriezellentyp bestimmt werden, wobei die gegenseitige Beeinflussung von Temperatur und Strom berücksichtigt werden kann. Beispielsweise kann eine zweidimensionale Korrekturmatrix erstellt werden, die einen Korrekturfaktor für jeweils einen Temperaturwert und einen Stromwert ausgibt, d.h. für ein Paar aus einem Temperatur- und Stromwert. Es können jeweils verschiedene Korrekturfaktoren für jeweils eine Lade- und einen Entladevorgang bestimmt werden.

Beispielsweise kann der absolute, korrigierte Ladezustand für jeweils eine Batteriezelle wie folgt ermittelt werden: Integration über den Strom über einen Zeitraum, in welchem der Strom näherungsweise konstant ist, zur Ermittlung der zugeführten bzw. entnommenen Ladungsmenge während dieses Zeitraums; Ermitteln des jeweiligen Korrekturfaktors in Abhängigkeit des Stroms und der Temperatur während dieses Zeitraums; und Gewichtung der zugeführten bzw. entnommenen Ladungsmenge mit den ermittelten Korrekturfaktor und Addieren dieser gewichteten Ladungsmenge zum absoluten korrigierten Ladezustand der jeweiligen Batteriezelle. Alternativ kann auch während der Integration über den Strom eine Gewichtung des Stroms mit einem jeweils aktuell ermittelten Korrekturwert in Abhängigkeit des aktuellen Stroms und der aktuell für die jeweilige Batteriezelle ermittelten Temperatur erfolgen. Die Gewichtung kann beispielsweise eine Multiplikation darstellen.

Somit kann beispielsweise für mindestens eine oder auch jede Batteriezelle der Vielzahl der Batteriezellen der absolute Ladezustand als Batteriezustandsinformation ermittelt werden.

Darüber hinaus kann auch die erfasste Spannung einer Batteriezelle in die Ermittlung des absoluten Ladezustands einfließen. So kann beispielsweise der absolute Ladezustand, sowohl unkorrigiert als auch korrigiert, auf Null gesetzt werden, wenn die Spannung der jeweiligen Batteriezelle unter einen Vordefinierten unteren Grenzwert fällt.

Der normierte Ladezustand kann beispielsweise auf Grundlage einer der zuvor erläuterten absoluten Ladezustände ermittelt werden, wobei beispielsweise einer der absoluten Ladezustände auf einen Wertebereich zwischen Null und Eins normiert werden kann, wobei Null einer vollkommen entladenen Batteriezelle und Eins einer komplett geladenen Batteriezelle entspricht. Der normierte Ladezustand kann aber auch einem absoluten Ladezustand, welcher auf einen prozentualen Wertbereich zwischen Null Prozent und Hundert Prozent normiert worden ist, entsprechen.

Darüber hinaus kann die Information über den Ladezustand der jeweiligen Batteriezelle auch einen auf einen eingeschränkten Kapazitätsbereich abgebildeten Ladezustand umfassen. Dieser auf einen eingeschränkten Kapazitätsbereich abgebildete Ladezustand, im Folgenden stets als abgebildeter Ladezustand bezeichnet, kann auf jedem der zuvor erläuterten absoluten oder normierten Ladezustände basieren. Darüber hinaus kann die Information über den Ladezustand der jeweiligen Batteriezellen auch eine Information des Ladezustands einer Mehrzahl von Batteriezellen der Vielzahl von Batteriezellen umfassen. D.h., es kann eine Information über den Ladezustand von mehreren Batteriezellen der Vielzahl von Batteriezellen ermittelt werden, beispielsweise für einen Block von Batteriezellen der Vielzahl von Batteriezellen, oder auch für sämtliche Batteriezellen der Vielzahl von Batteriezellen. So kann beispielsweise aus der Information über den Ladezustand von sämtlichen Batteriezellen der Vielzahl von Batteriezellen, welche als Batteriepack betrachtet werden können, geschlossen werden.

Beispielsweise kann die Information über den Ladezustand einer Mehrzahl von Batteriezellen der Vielzahl von Batteriezellen mindestens einen der folgenden Werte umfassen: absoluter Ladezustand; normierter Ladezustand; und ein auf einen eingeschränkten Kapazitätsbereich abgebildeter Ladezustand.

Eine Ausgestaltung der Erfindung sieht vor, dass die Vorrichtung dazu eingerichtet ist, eine Referenzladung der Vielzahl von Batteriezellen durchzuführen.

Bei dieser Referenzladung wird beispielsweise jede Batteriezelle der Vielzahl von Batteriezellen durch ein vordefiniertes Ladeverfahren bis annähernd an die noch zur Verfügung stehende Nennkapazität der jeweiligen Batteriezelle geladen.

Beispielsweise kann diese Referenzladung dann durchgeführt werden, wenn ein für eine oder auch mehrere Batteriezellen ermittelter absoluter, unkorrigierter Ladezustand mehr als ein vorgegebenes Maß von dem entsprechenden absoluten, korrigierten Ladezustand abweicht. Nach der durchgeführten Referenzladung kann beispielsweise der Wert für den absoluten, unkorrigierten Ladezustand, sowie der Wert für den absoluten, unkorrigierten Ladezustand für jede der geladenen Batteriezellen auf den jeweiligen Wert der noch zur Verfügung stehenden Nennkapazität der jeweiligen Batteriezelle gesetzt werden.

Eine Ausgestaltung der Erfindung sieht vor, dass die Information über die Anzahl der Lade- und/oder Entladezyklen der jeweiligen Batteriezelle einen Wert über deinen aktuellen Teilladezyklus umfasst, welcher ein Maß für die der jeweiligen Batteriezelle entnommenen bzw. zugeführten Ladung während eines Lade- bzw. eines Entladevorgangs darstellt. Der Wert über einen aktuellen Teilladezyklus einer Batteriezelle kann auf dem Integral des Lade- bzw. Entladestroms seit dem letzten Wechsel zwischen einem Entlade bzw. Ladevorgang basieren. Beispielsweise kann dieser Wert über einen aktuellen Teilladezyklus zu beginn eines Lade- oder Entladevorgangs auf Null gesetzt werden, wobei Nachfolgend basierend auf dem beschriebenen Integral des Lade- bzw. Entladestroms bestimmt wird, wieviel Ladung der jeweiligen Batteriezelle entweder zugeführt oder entnommen wird. Nach Beendigung des jeweiligen Lade- bzw. Entladevorgangs stellt der Wert über einen aktuellen Teilladezyklus somit ein Maß für die der jeweiligen Batteriezelle zugeführten bzw. entnommenen Ladung, jeweils in Abhängigkeit davon, ob ein Lade- bzw. Entladevorgang durchgeführt worden ist. Das Vorzeichen des Werts über einen aktuellen Teilladezyklus gibt dabei an, ob es sich dabei um einen Lade- bzw. Entladevorgang handelt. Bei einem positiven Vorzeichen wurde Ladung zugeführt, d.h. es handelt sich um einen Ladevorgang, während ein negatives Vorzeichen einen Entladevorgang beschreibt.

Eine Ausgestaltung der Erfindung sieht vor, dass die Information über die Anzahl der Lade- und/oder Entladezyklen der jeweiligen Batteriezelle einen Wert für einen Ladezyklus und einen Wert für einen Entladezyklus umfasst, wobei das Ermitteln des Werts über den aktuellen Teilladezyklus während eines Lade- bzw. Entladevorgangs solange durchgeführt wird, bis der jeweilige Lade- bzw. Entladevorgang beendet ist, wobei nach der Beendigung des jeweiligen Lade- bzw. Entladevorgangs ein auf dem Wert über den aktuellen Teilladezyklus basierenden Werts auf den Wert für einen Ladezyklus aufaddiert wird, wenn ein Ladevorgang beendet wurde; und wobei ein auf dem Wert über einen aktuellen Teilladezyklus basierenden Werts auf den Wert für einen Entladezyklus aufaddiert wird, wenn ein Entladezyklus beendet worden ist; und zurücksetzten des Werts für einen aktuellen Teilladezyklus.

Wurde beispielsweise ein Ladevorgang beendet, so kann der vorher ermittelte Wert über den aktuellen Teilladezyklus für eine Batteriezelle auf den Wert für einen Ladezyklus dieser Batteriezelle aufaddiert werden. Dieses Aufaddieren kann beispielsweise vorab eine Gewichtung des jeweiligen Werts über den aktuellen Teilladezyklus der jeweiligen Batteriezelle mit einem Faktor umfassen, wobei beispielsweise ein Wert über einen aktuellen Teilladezyklus der annähernd 100 Prozent der Nominalkapazität der jeweiligen Batteriezelle entspricht, mit einem Faktor eins gewichtet wird, während kleinere Teilladezyklen, welche beispielsweise nur einen geringeren Prozentsatz der Nominalkapazität entsprechen, mit einem geringeren Faktor, d.h. zwischen Null und Eins gewichtet werden. Somit kann dieser Gewichtungsfaktor beispielsweise proportional zur Größe des jeweiligen Werts für einen Teilladezyklus sein.

Darüber hinaus kann auch beispielsweise eine Gewichtung des Werts über den aktuellen Teilladezyklus auf Grundlage der zeitlichen Dauer des jeweiligen Entlade- bzw. Ladevorgangs erfolgen. So kann beispielsweise der Wert über den aktuellen Teilladezyklus zusätzlich durch einen Wert, der proportional zur Dauer des jeweiligen Entladen- bzw. Ladevorgangs ist, dividiert werden. Es können auch noch weitere Algorithmen zur Gewichtung des Werts über den aktuellen Teilladezyklus verwendet werden. Die zuvor getroffen Ausführungen über die Gewichtung eines Werts über den aktuellen Teilladezyklus gelten in gleicher Maßen für einen Entladevorgang.

Somit kann, in Abhängigkeit davon, ob ein Ladevorgang oder ein Entladevorgang beendet wurde, entweder der Wert für den Ladevorgang oder der Wert für den Entladevorgang auf Grundlage des ermittelten Werts über den aktuellen Teilladezyklus für eine jeweilige Batteriezelle aktualisiert werden, wobei diese Aktualisierung durch aufaddieren eines auf dem Wert über den aktuellen Teilladezyklus basierenden Werts auf den jeweiligen Wert für einen Ladezyklus bzw. auf den jeweiligen Wert für einen Entladezyklus erfolgen kann. Dieser auf dem Wert über den aktuellen Teilladezyklus basierender Wert kann der Wert über den aktuellen Teilladezyklus selbst darstellen, oder einer der zuvor beschrieben gewichteten Werte über den aktuellen Teilladezyklus darstellen, oder ein anderweitig gewichteter Wert über den aktuellen Teilladezyklus darstellen.

Somit kann beispielsweise für mindestens eine Batteriezelle der Vielzahl von Batteriezellen jeweils ein Wert für einen Ladezyklus und jeweils ein Wert für einen Entladezyklus aktualisiert werden.

Eine Ausgestaltung der Erfindung sieht vor, dass die Information über die Anzahl der Lade- und/oder Entladezyklen der jeweiligen Batteriezelle jeweils einen Wert für die Anzahl der Lade- bzw. Entladezyklen umfasst, wobei die Erfindung vorsieht, zu vergleichen, ob der Wert für einen Lade- oder Entladezyklus einen Referenzwert erreicht oder überschreitet, und den entsprechenden Wert für die Anzahl der Lade- bzw. Entladezyklen inkrementiert, wenn der Referenzwert erreicht oder überschritten wurde.

Dieser Referenzwert kann beispielsweise der Wert der verfügbaren nominalen Kapazität der jeweiligen Batteriezelle darstellen, welcher wiederum von der jeweiligen Lebensdauer der jeweiligen Batteriezelle abhängig sein kann. Dieser Referenzwert kann jedoch auch durch einen anderen, geeigneten Kapazitätswert bestimmt werden. Wurde beispielsweise der Wert für einen Ladevorgang oder für einen Entladevorgang einer Batteriezelle aktualisiert, wie zuvor erläutert, so kann überprüft werden, ob dieser Wert für einen Ladevorgang bzw. Entladevorgang größer oder gleich dem Referenzwert liegt.

Wurde für eine jeweilige Batteriezelle festgestellt, dass der Referenzwert entweder erreicht oder überschritten wurde, so kann entweder der Wert für die Anzahl der Ladevorgänge inkrementiert oder der Wert für die Anzahl der Entladevorgänge inkrementiert werden, d.h. es kann somit jeder Batteriezelle der Vielzahl von Batteriezellen jeweils ein Wert für die Anzahl der Ladevorgänge und ein Wert für die Anzahl der Entladevorgänge zugeordnet werden. Nach der Inkrementierung kann der entsprechende Wert für einen Ladezyklus bzw. für einen Entladezyklus zurückgesetzt werden.

Der Wert über die Anzahl über die Ladevorgänge für eine Batteriezelle kann somit als Maß für die Anzahl der äquivalenten Volllastladezyklen betrachtet werden, während der Wert für die Anzahl der Entladevorgänge einer jeweiligen Batteriezelle als Maß für die Anzahl der äquivalenten Volllastentladezyklen betrachtet werden kann. Diese Anzahl der äquivalenten Volllastzyklen stellen beispielsweise ein Maß für das Alter der jeweiligen Batteriezellen dar. Somit kann beispielsweise die Vorrichtung dazu eingerichtet sein, die verfügbare, nominale Kapazität einer jeweiligen Batteriezelle in Abhängigkeit des Werts für die Anzahl der Ladevorgänge und/oder des Werts für die Anzahl der Entladevorgänge einer jeweiligen Batteriezelle zu ermitteln, wobei beispielsweise ausgehend von einer ursprünglichen Nominalkapazität eine Reduktion dieser Nominalkapazität in Abhängigkeit der Anzahl der Ladevorgänge bzw. der Anzahl der Entladevorgänge durchgeführt wird, um die jeweilige verfügbare nominale Kapazität der jeweiligen Batteriezelle zu ermitteln. Darüber hinaus können auch noch weitere Faktoren zur Ermittlung der verfügbaren nominalen Kapazität der jeweiligen Batteriezelle berücksichtigt werden, wie beispielsweise weitere Gesundheitsinformationen über diese Batteriezelle, welche im nachfolgenden auch genauer erläutert werden.

Beispielsweise kann die Vorrichtung dazu eingerichtet sein, auf Grundlage der ermittelten Batteriezustandsinformationen beispielsweise einen Ladevorgang und/oder Entladevorgang der Vielzahl von Batteriezellen zu steuern bzw. zu regeln.

Eine Ausgestaltung der Erfindung sieht vor, den Ladestrom für mindestens eine Batteriezelle der Vielzahl von Batteriezellen während eines Ladevorgangs auf Grundlage der ermittelten Batteriezustandsinformationen abzusenken.

Dieses Absenken des Ladestroms kann beispielsweise durch die Ansteuerung eines steuerbaren Ladegeräts erfolgen und/oder durch das Einschalten mindestens einen schaltbaren Ausgleichselement, wobei jedes der schaltbaren Ausgleichselemente jeweils einer Batteriezelle zugeordnet ist und dazu eingerichtet ist, einen Bypasspfad parallel zu der jeweiligen Batteriezelle ein- bzw. auszuschalten, wobei über diesem Bypasspfad zumindest ein Teil des Ladestroms der jeweiligen Batteriezelle um diese Batteriezelle herum geleitet werden kann. So kann beispielsweise überprüft werden, ob die Spannung einer Batteriezelle der Vielzahl von Batteriezellen während eines Ladevorgangs einen vordefinierten Grenzwert erreicht, und nach Erreichen dieses Grenzwertes kann ein an die Schnittstelle der Vorrichtung angeschlossenes Ladegerät derart angesteuert werden, dass der vom Ladegerät bereitgestellte Ladestrom derart abgesenkt wird, dass die Spannung an dieser Batteriezelle während des Ladevorgangs konstant auf dem vordefinierten Grenzwert gehalten wird, oder zumindest, dass die Spannung an dieser Batteriezelle während des Ladevorgangs konstant den vordefinierten Grenzwert nicht überschreitet. Somit kann der Ladestrom dauernd reduziert werden und die Spannung über dieser Batteriezelle konstant bzw. maximal auf dem vordefinierten Grenzwert gehalten werden. Der vordefinierte Grenzwert kann beispielsweise die Ladeentspannung einer Batteriezelle sein, die vom jeweiligen Typ der Batteriezelle abhängt.

Eine Ausgestaltung der Erfindung sieht vor, dass eine Zeitdauer für jeweils eine Batteriezelle der mindestens einen Batteriezelle ermittelt wird, für die der Ladestrom der jeweiligen Batteriezelle abzusenken ist, auf Grundlage der gespeicherten Batteriezustandsinformationen, und das der Ladestrom für jede der mindestens einen Batteriezelle für die jeweils ermittelte Zeitdauer abgesenkt wird.

Die für das Absenken des Ladestroms verwendeten Batteriezustandsinformationen können beispielsweise die Reihenfolge in welcher mindestens zwei Batteriezellen der Vielzahl von Batteriezellen während eines Ladevorgangs jeweils eine vordefinierte Spannung erreichen, umfassen. Die Vorrichtung kann beispielsweise dazu eingerichtet sein, während eines Ladevorgangs die einzelnen Spannungen der Batteriezellen zu überwachen und abzuspeichern, in welcher Reihenfolge die jeweiligen Batteriezellen die vordefinierte Spannung erreichen. Diese Reihenfolge stellt beispielsweise eine Information über die Gesundheit der jeweiligen Batteriezellen dar, da eine schlechtere Batteriezelle während eines Ladevorgangs die vordefinierte Spannung eher erreicht, als eine bessere Batteriezelle.

Die für das Absenken des Ladestroms verwendeten Batteriezustandsinformationen können ferner beispielsweise eine Zeitinformation über den Zeitpunkt, zu welchem eine jeweilige Batteriezelle während eines Ladevorgangs jeweils die vordefinierte Spannung erreicht hat, umfassen. Beispielsweise kann die Vorrichtung dazu eingerichtet sein, diese Zeitinformation über den Zeitpunkt, zu welchem eine jeweilige Batteriezelle während eines Ladevorgangs jeweils die vordefinierte Spannung erreicht hat, zu ermitteln. Diese Zeitinformation stellt beispielsweise ebenfalls eine Information für die Gesundheit der jeweiligen Batteriezellen dar.

Die für das Absenken des Ladestroms verwendeten Batteriezustandsinformationen können ferner beispielsweise auch der Wert für die Anzahl der Lade- bzw. Entladezyklus für die mindestens eine Batteriezelle umfassen, welche ebenfalls als ein Maß auch der Wert für die Anzahl der Lade- bzw. Entladezyklus für jeweils eine Batteriezelle der mindestens einen Batteriezelle verwendet werden, die auch ein Maß über die Information der Gesundheit der jeweiligen Batteriezellen darstellen. Somit kann auch die Zyklenberechnung zur Berechnung der Zeitdauer herangezogen werden, da aufgrund der Alterung die Zellen bezüglich Innenwiderstand und anderer charakteristischer Größen stärker differieren und dies somit bei der Absenkung des Ladestroms berücksichtigt werden kann.

Die zuvor beschriebenen Kriterien zur Berechnung einer Zeitdauer zur Absenkung eines Ladestroms für eine jeweilige Batteriezelle können auch miteinander kombiniert werden.

Somit kann auf Grundlage dieser Informationen über die Gesundheit der jeweiligen Batteriezellen jeweils ein Zeitraum für eine der mindestens einen Batteriezelle ermittelt werden, wobei dieser Zeitraum beispielsweise für eine Batteriezelle mit einer schlechteren Gesundheit länger ausfällt, als ein Zeitraum für eine Batteriezelle mit einer besseren Gesundheit. Somit kann erreicht werden, dass die schlechteren Batteriezellen während eines Ladevorgangs für eine größere Zeitdauer mit einem abgesenkten Ladestrom geladen werden, der auch gegen Null gehen kann, während die besseren Batteriezellen während eines Ladevorgangs nur für einen kurzen Zeitraum oder auch überhaupt gar nicht mit einem abgesenkten Ladestrom geladen werden. Somit kann ein Ausgleichen der verschiedenen Batteriezellen während eines Ladevorgangs erfolgen.

Eine Ausgestaltung der Erfindung sieht vor, dass geprüft wird, ob die Spannung einer Batteriezelle der Vielzahl von Batteriezellen einen vorgegebenen Grenzwert überschreitet oder ob diese Spannung einer Batteriezelle plötzlich ansteigt, wobei der Ladestrom für diese Batteriezelle für die ermittelte Zeitdauer abgesenkt wird, wenn die Spannung dieser Batteriezelle den vorgegebenen Grenzwert überschritten hat, oder wenn die Spannung plötzlich angestiegen ist.

Diese Zeitdauer kann beispielsweise über eine jeweilige Batteriezelle analog zu der zuvor erläuterten ermittelten Zeitdauer ermittelt werden, wobei allerdings diese Zeitdauer auch beispielsweise erst nach Detektion des Überschreiten der Spannung und/oder nach Detektion des plötzlichen Spannungsanstiegs ermittelt werden kann. Beispielsweise kann nach dieser Detektion festgestellt werden, wie hoch die Werte für einen Ladezyklus von weiteren Batteriezellen in Bezug auf diese Batteriezelle für die die Spannungsüberschreitung bzw. der plötzliche Spannungsanstieg festgestellt worden ist, wobei in Abhängigkeit einer Ladungsdifferenz, die auf Grundlage des Werts für einen Ladezyklus dieser Batteriezelle und mindestens einen weiteren Wert für einen Ladezyklus von mindestens einer weiteren Batteriezelle eine proportionale Zeitdauer für diese Batteriezelle bestimmt werden soll, an der der Ladestrom für diese Batteriezelle abzusenken ist. Dieses Absenken des Ladestroms für die ermittelte Zeitdauer kann an einem beliebigen späteren Zeitpunkt geschehen, dies kann bereits direkt nach Detektion erfolgen, oder aber zu einem späteren Zeitpunkt. Diese Ermittlung der Zeitdauer für das Absenken des Ladestroms für die jeweilige Batteriezelle kann auch mit den zuvor genannten Kriterien zur Ermittlung einer Zeitdauer zum Absenken des Ladestroms kombiniert werden. So kann beispielsweise durch die Berücksichtigung der Werte für die Anzahl der Lade- und/oder Entladezyklen die Alterung der verschiedenen Batteriezellen bezüglich Innenwiderstand und anderer charakteristischen Größen zur Berechnung der Zeitdauer des Abschalten des Ladestroms für die jeweilige Batteriezelle berücksichtigt werden. Somit kann beispielsweise für eine Batteriezelle, welche eine schlechtere Gesundheit aufweist, wobei diese Gesundheit in Abhängigkeit des Werts der Anzahl der Lade- und/oder Entladzyklen, in Abhängigkeit der Ladungsdifferenzen zwischen verschiedenen Zellen, oder in Abhängigkeit von weiteren Kriterien, wie zuvor erläutert, ermittelt werden.

Eine Ausgestaltung der Erfindung sieht vor, dass mindestens einer Batteriezelle der mindestens einen Batteriezelle jeweils ein schaltbares Ausgleichselement zugeordnet ist, welches dazu eingerichtet ist, einen Bypasspfad parallel zu der jeweiligen Batteriezelle ein- bzw. auszuschalten, wobei das Absenken des Ladestroms für mindestens eine Batteriezelle der Vielzahl von Batteriezellen umfasst: Einschalten des jeweiligen Bypasspfads von mindestens einem schaltbaren Ausgleichselement.

Eine Ausgestaltung der Erfindung sieht vor, dass das Absenken eines Ladestroms für mindestens eine Batteriezelle der Vielzahl von Batteriezellen umfasst: Ansteuern eines Ladegeräts, welches mindestens einer Batteriezelle der mindestens einen Batteriezelle zugeordnet ist, zum Absenken des von dem Ladegerät für die Mindestens eine Batteriezelle der mindestens einen Batteriezelle bereit gestellten Ladestroms.

Eine Ausgestaltung der Erfindung sieht vor, dass die Batteriezustandsinformationen während eines weiteren Ladevorgangs aktualisiert werden.

Somit können permanent die Batteriezustandsinformationen aktualisiert werden, wobei beispielsweise während eines Ladevorgangs nach der zuvor erläuterten Detektion einer Überschreitung einer vordefinierten Spannung und/oder eines festgestellten plötzlichen Spannungsanstiegs bei einer bestimmten Batteriezelle die aktuell vorhandenen Batteriezustandsinformationen, wie beispielsweise Informationen über den Ladezustand dieser Batteriezellen und/oder von mindestens einer weiteren Batteriezelle für die weitere Steuerung des Ladevorgangs, insbesondere im Hinblick auf die Ermittlung einer Zeitdauer für das Absenken eines Ladestroms für eine Batteriezelle, berücksichtigt werden.

Die Vielzahl von Batteriezellen kann beispielsweise als Batteriepack ausgebildet sein, welches als Ersatz bzw. als Austauschsatz für einen herkömmlichen Batteriepack bestehend aus Bleiakkumulatoren eingesetzt werden kann. Beispielsweise kann dieses Batteriepack für einen Gabelstapler verwendet werden.

Der zuvor genannte Hauptleistungsschalter kann beispielsweise in einer Anschlussleitung platziert sein, welche die Vielzahl von Batteriezellen mit einem Verbraucher oder einer Ladeeinrichtung verbinden kann. Dieser Hauptleistungsschalter kann beispielsweise durch einen Czonk-Schalter realisiert werden, aber auch durch einen anderen geeigneten Leistungsschalter. Darüber hinaus kann die Steuereinrichtung dazu eingerichtet sein, für jede einzelne Batteriezelle der Vielzahl von Batteriezellen die jeweils ermittelten Parameter und/oder die ermittelten Batteriezustandsinformationen zu speichern, sodass diese über eine weitere Schnittstelle an ein externes Auslesegerät gesendet werden können. Somit kann eine Dokumentation der jeweiligen Batteriezellen der Vielzahl von Batteriezellen erfolgen. Auf Grundlage dieser erfassten Daten kann somit beispielsweise die Gesundheit einer Batteriezelle der Vielzahl von Batteriezellen bestimmt werden, sodass beispielsweise die Steuereinrichtung dazu eingerichtet sein kann, eine schlechte Gesundheit einer Batteriezelle auf Grundlage der jeweiligen Batteriezustandsinformationen dieser Batteriezelle zu ermitteln und beispielsweise dies über die Ausgabemittel anzuzeigen bzw. auszugeben. Somit kann eine schlechte Batteriezelle erkannt werden und rechtzeitig ausgetauscht werden. Darüber hinaus kann diese Dokumentation auch als Basis für Leasingverträge von Flurförderzeugen oder als Basis auch zur Arbeitszeiterfassung eines eingesetzten Flurförderzeugs verwendet werden.

Die Erfindung wird im Folgenden anhand von Ausführungsbeispiele zeigenden Zeichnungen näher erläutert.

Dabei zeigen:

Fig. 1a:  eine schematische Darstellung eines Flussdiagramms einer ersten beispielhaften Ausführungsform eines Verfahrens;

Fig. 1b:  eine schematische Darstellung einer ersten beispielhaften Ausführungsform einer Vorrichtung;

Fig. 1c:  eine schematische Darstellung einer ersten beispielhaften Ausführungsform eines Systems;

Fig. 1d:  eine schematische Darstellung einer ersten beispielhaften Ausführungsform einer Schnittstelle für eine Batteriezelle;

Fig. 1e:  eine schematische Darstellung einer zweiten beispielhaften Ausführungsform eines Systems;

Fig. 2a:  eine schematische Darstellung eines Flussdiagramms einer zweiten beispielhaften Ausführungsform eines Verfahrens;

Fig. 2b:  eine schematische Darstellung eines Flussdiagramms einer dritten beispielhaften Ausführungsform eines Verfahrens;

Fig. 2c:  eine schematische Darstellung eines Flussdiagramms einer vierten beispielhaften Ausführungsform eines Verfahrens;

Fig. 2d:  eine schematische Darstellung eines Flussdiagramms einer fünften beispielhaften Ausführungsform eines Verfahrens;

Fig. 3a:  eine schematische Darstellung eines Flussdiagramms einer sechsten beispielhaften Ausführungsform eines Verfahrens;

Fig. 3b:  eine schematische Darstellung eines Flussdiagramms einer siebten beispielhaften Ausführungsform eines Verfahrens;

Fig. 4a:  eine schematische Darstellung eines Flussdiagramms einer achten beispielhaften Ausführungsform eines Verfahrens;

Fig. 4b:  eine schematische Darstellung eines Flussdiagramms einer neunten beispielhaften Ausführungsform eines Verfahrens;

Fig. 5a:  eine schematische Darstellung einer dritten beispielhaften Ausführungsform eines Systems;

Fig. 5b:  eine schematische Darstellung einer vierten beispielhaften Ausführungsform eines Systems.

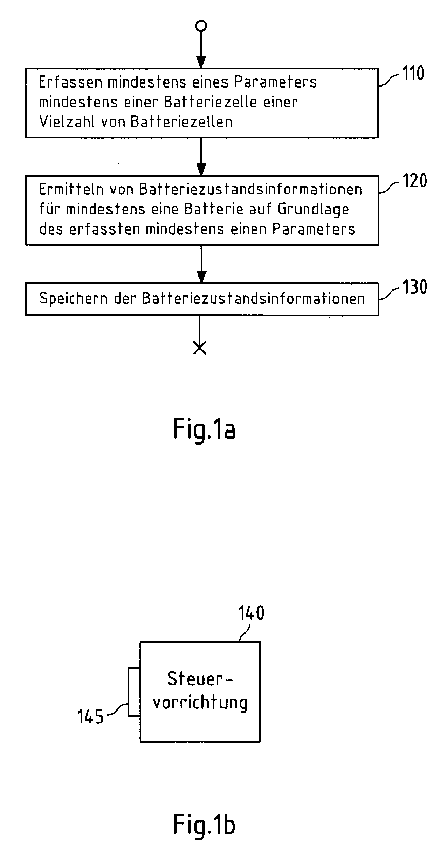

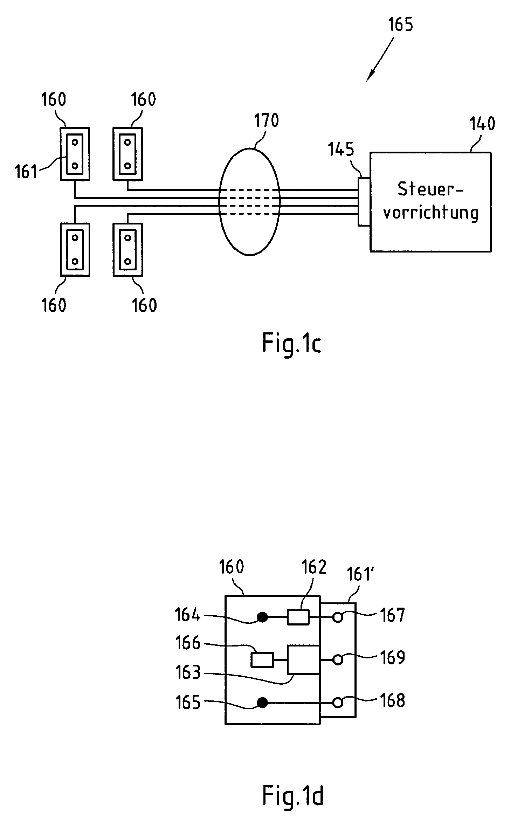

Fig. 1a stellt eine schematische Darstellung eines Flussdiagramms einer ersten beispielhaften Ausführungsform eines Verfahrens dar, welches im Folgenden mit der in Fig. 1b gezeigten schematischen Darstellung einer ersten beispielhaften Ausführungsform einer Steuervorrichtung 140 und der in Fig. 1c gezeigten schematischen Darstellung einer ersten beispielhaften Ausführungsform eines Systems 165 erläutert wird.

Die in den Fig. 1b und 1c dargestellte Steuervorrichtung 140 ist dazu eingerichtet, das in Fig. 1a dargestellt Verfahren durchzuführen, wobei die Steuervorrichtung 140 eine Schnittstelle 145 aufweist, über welche die Steuervorrichtung 140 Daten empfangen und/oder Daten versenden kann.

Die Steuervorrichtung 150 kann beispielsweise einen Mikroprozessor, Speichermittel, und/oder weitere Schnittstellen aufweisen.

Das Verfahren umfasst das Erfassen mindestens einen Parameters mindestens einer Batteriezelle 160 einer Vielzahl von Batteriezellen 160, wie in Schritt 110 in Fig. 1a gezeigt. Beispielsweise kann mindestens ein Parameter genau jeweils einer Batteriezelle der Vielzahl von Batteriezellen 160, zugeordnet sein, es kann aber auch mindestens ein Parameter jeweils einer Mehrzahl von Batteriezellen der Vielzahl von Batteriezellen 160 zugeordnet sein. Der mindestens eine erfasste Parameter kann beispielsweise mindestens ein Parameter aus den Parametern Spannung, Strom und Temperatur sein.

Die Batteriezellen 160 können elektrochemische Batteriezellen darstellen, wie beispielsweise Akkumulatorbatteriezellen und insbesondere Lithium-Ionen Akkumulatorbatteriezellen oder dergleichen. Diese Batteriezellen 160 können beispielsweise in einem Batteriepack für Elektrofahrzeuge, insbesondere Flurförderzeuge, angeordnet sein.

Die Elektrofahrzeuge können beispielsweise Hybridkraftfahrzeuge, elektrisch betriebene Fahrzeuge wie beispielsweise Flurförderzeuge, elektrische Fahrräder, elektrische Rollstühle oder dergleichen darstellen.

Beispielsweise kann mindestens einer Batteriezelle mindestens ein Sensormittel zugeordnet sein, wobei das jeweilige Sensormittel einer Batteriezelle dazu eingerichtet ist, den mindestens einen Parameter dieser jeweiligen Batteriezelle 160 zu ermitteln und über die Schnittstelle 145 an die Steuervorrichtung 140 zu kommunizieren. Beispielsweise kann ein Sensormittel zwei Kontakte zum Abgreifen der Spannung der jeweiligen Batteriezelle aufweisen, und/oder einen Temperatursensor zur Ermittlung der Temperatur der jeweiligen Batteriezelle 160 aufweisen. Darüber hinaus kann das Sensormittel beispielsweise auch Mittel zum Detektieren eines Stroms, welcher durch die jeweilige Batteriezelle 160 fließt, umfassen. Die Sensormittel können eine Schnittstelle 161 aufweisen, welche dazu eingerichtet ist, mit der Schnittstelle 145 der Steuervorrichtung 140 verbunden zu werden. Die Schnittstelle 145 der Steuervorrichtung 140 ist daher derart eingerichtet, dass sie mit einer Vielzahl von Sensormitteln über die jeweiligen Schnittstellen 161 der Sensormittel kommunizieren kann. Somit kann die Steuervorrichtung 140 die jeweiligen Parameter von mindestens einer Batteriezelle 160 der Vielzahl von Batteriezellen 160 ermitteln. Wie in Fig. 1c durch die gestrichelte Verbindung zwischen der Schnittstelle 145 der Steuervorrichtung 140 und den Schnittstellen 161 der Sensormittel beispielhaft angedeutet, können zwischen der Schnittstelle 145 der Steuervorrichtung 140 und zwischen den Sensormittel noch weitere Komponenten angeordnet sein. Beispielsweise kann auch ein Bussystem zur Übertragung von Daten zwischen den Sensormitteln und der Schnittstelle 145 der Steuervorrichtung verwendet werden.

Fig. 1d zeigt eine schematische Darstellung einer ersten beispielhaften Ausführungsform einer Schnittstelle 161' von Sensormitteln für eine Batteriezelle 160. Diese Schnittstelle kann beispielsweise für die in Fig. 1c dargestellte Schnittstelle 161 verwendet werden.

Die Schnittstelle 161' umfasst zwei Kontakte 167, 168, welche jeweils mit einem Pol 164, 165 der Batteriezelle 160' verbunden sind und somit Sensormittel für die Messung der Spannung der Batteriezelle 160 darstellen. Beispielsweise kann der Pol 164 der Pluspol sein, wobei zwischen dem Kontakt 167 und dem Pol 164 eine Sicherung 162 angeordnet sein kann.

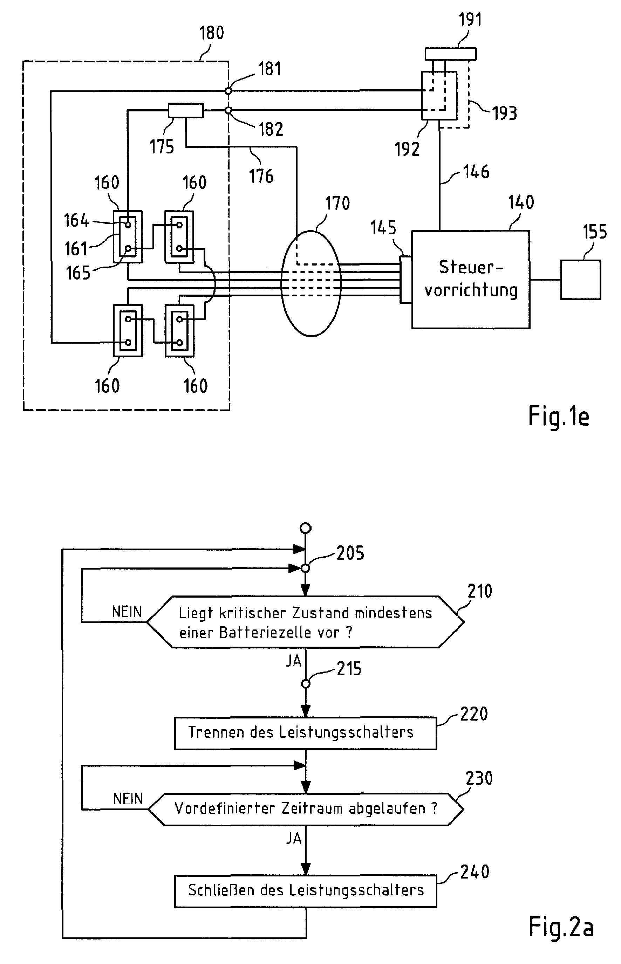

Ferner ist die Schnittstelle 161' mit einem Temperatursensor 166 verbunden, welcher dazu eingerichtet ist, die Temperatur der Batteriezelle 160 zu messen. Die Schnittstelle 161' kann beispielsweise eine Sub-Schnittstelle 169 zur Ausgabe einer Information über die vom Temperatursensor 166 gemessene Temperatur umfassen. Beispielsweise kann die Schnittstelle eine Kommunikationseinheit 163 umfassen, welche mit dem Temperatursensor 166 verbunden ist und dazu eingerichtet ist, mit der Schnittstelle 145 der Steuervorrichtung 140 zu kommunizieren und mindestens einen der jeweiligen Batteriezelle 160 zugeordneten Parameter an die Steuervorrichtung 140 zu übertragen. So kann die Kommunikationseinheit 163 beispielsweise auch für eine bidirektionale Datenübertragung zur Steuervorrichtung 140 eingerichtet sein, und die Kommunikationseinheit kann beispielsweise einen Buskoppler 163 darstellen, wobei zwischen den Schnittstellen 161' der Sensormittel der Batteriezellen 160 und der Schnittstelle 145 der Steuervorrichtung 140 ein Bus zur Übertragung der Daten ausgebildet sein kann, wie in den Figuren 1c und 1e beispielhaft und optional durch Bezugszeichen 170 angedeutet ist.

Die Kommunikationseinheit 163 kann auch mit den Polen 164 und 165 verbunden sein und dazu eingerichtet sein, eine an den Polen 164 und 165 gemessene Spannung über die Sub-Schnittstelle 169 auszugeben. Für diesen Fall müssen die Kontakte 167 und 168 der Schnittstelle 161' nicht zwingend mit der Schnittstelle 145 des Steuergeräts 145 verbunden sein.

Die Kommunikationseinheit 163 kann auch Speichermittel zur Speicherung von Daten aufweisen. So können beispielsweise in den Speichermittel erfasste Parameter, wie z.B. Spannung, und/oder Temperatur und/oder Strom zwischengespeichert werden, und beispielsweise auf Anforderung von der Steuervorrichtung 140 an die Steuervorrichtung übertragen werden.

Die Steuervorrichtung 140 ist dazu eingerichtet, auf Grundlange des Erfassten mindestens einen Parameters Batteriezustandsinformationen für mindestens eine Batteriezelle der Vielzahl von Batteriezellen 160 zu ermitteln, wie beispielhaft in Schritt 120 in Fig. 1a dargestellt. Diese ermittelten Batteriezustandsinformation werden anschließend in der Steuervorrichtung 140 gespeichert.

Darüberhinaus kann die Steuervorrichtung 140 von den Sensormitteln 140 der jeweiligen Batteriezellen 160 weitere Parameter empfangen. Beispielsweise kann jeder Batteriezelle 160 ein eindeutiger Identifikator zugeordnet sein, welcher als Parameter beispielsweise in den Sensormitteln eingespeichert bzw. einspeicherbar ist, und welcher von der Steuervorrichtung 140 über die Schnittstelle 161' des jeweiligen Sensormittels ausgelesen werden kann. Beispielsweise kann dieser Identifikator in den Speichermitteln der Schnittstelle 161' eingespeichert sein. Somit können von einem Sensormittel empfangene Parameter, wie beispielsweise Temperatur und/oder Spannung und/oder Strom auf Grundlage des empfangenen Identifikators genau einer Batteriezelle 160 zugeordnet werden, und es können auch auf Grundlage dieser empfangenen Parameter ermittelte Batteriezustandsinformationen beispielsweise genau einer Batteriezelle zugeordnet werden.

Die Steuervorrichtung 140 kann dazu eingerichtet sein, auf Grundlage dieser ermittelten Batteriezustandsinformationen beispielsweise einen Ladevorgang und/oder Entladevorgang der Vielzahl von Batteriezellen 160 zu steuern bzw. zu regeln. Des weiteren kann die Steuervorrichtung 140 dazu eingerichtet sein, Information über die erfassten Parameter und/oder die ermittelten Batteriezustandsinformation an einem Ausgabemittel 155 auszugeben. Die Ausgabe der Information durch die Ausgabemittel 155 kann beispielsweise optisch und/oder akustisch erfolgen.

Diese ermittelten Batteriezustandsinformationen können beispielsweise mindestens eine der folgenden Informationen umfassen: die Reihenfolge, in welcher die Batteriezellen während eines Ladevorgangs jeweils eine vordefinierte Spannung erreichen; Zeitinformationen über den Zeitpunkt, zu welchem die jeweilige Batteriezelle eine vordefinierte Spannung während eines Ladevorgangs erreicht; Information über den Ladezustand der jeweiligen Batteriezelle; Information über einen kritischen Zustand einer jeweiligen Batteriezelle; und Informationen über die Anzahl der Ladeund/oder Endladezyklen der jeweiligen Batteriezellen.

Fig. 1e zeigt eine schematische Darstellung einer zweiten beispielhaften Ausführungsform eines Systems, welche auf dem in Fig. 1c dargestellten ersten beispielhaften Ausführungsform eines Systems basiert.

Das in Fig. 1e dargestellte System kann beispielsweise einen Stromsensor 175 umfassen, welcher einer Mehrzahl von Batteriezellen 160, wie hier beispielsweise durch die gestrichelte Linie 180 dargestellt, zugeordnet ist. Dieser Stromsensor 175 ist somit eingerichtet, einen Strom, welcher dieser Mehrzahl von Batteriezellen 160 zugeordnet ist, zu erfassen, und über eine Verbindung 176 an die Schnittstelle 145 der Steuervorrichtung 140 zu übertragen. Beispielsweise können diese Mehrzahl von Batteriezellen 160 in einem Block 180 angeordnet sein, wobei die Mehrzahl von Batteriezellen 160 parallel und/oder in Reihe geschaltet sein kann. Ist die Mehrzahl von Batteriezellen 160 in Reihe geschaltet, wie beispielhaft in Fig. 1e dargestellt, so ist der Stromsensor 175 dazu eingerichtet, den Strom, welcher durch jede der Batteriezellen 160 der Mehrzahl von Batteriezellen 160 in dem Block 180 zu erfassen.

Das System kann beispielsweise mehrere Blöcke 180 mit jeweils einer Mehrzahl von Batteriezellen 160 umfassen, welche beispielsweise jeweils von einem Stromsensor 175 überwacht werden. Der Stromsensor 175 kann beispielsweise durch einen Widerstand realisiert werden, wie beispielsweise ein Shunt-Widerstand, oder durch einen anderen geeigneten Sensor realisiert werden.

Die jeweiligen Blöcke 180 mit jeweils einer Mehrzahl von Batteriezellen 160 können beispielsweise parallel und/oder in Reihe geschaltet werden, wobei diese Verschaltung über die jeweiligen Kontakte 181 und 182 eines jeweiligen Blocks 180 einer Mehrzahl von Batteriezellen 160 erfolgen kann. In Fig. 1e ist aus Gründen der Übersichtlichkeit nur ein einziger Block 180 einer Mehrzahl von Batteriezellen 160 dargestellt, wobei ein System auch eine Mehrzahl von Blöcken 180 umfassen kann.

Das in Fig. 1e beispielhaft dargestellte System umfasst ferner eine Schnittstelle 191, welche mit der Vielzahl von Batteriezellen 160 verbunden ist, und zur Stromaufnahme und/oder Stromabgabe, beispielsweise während eines Ladevorgangs bzw. eines Entladevorgangs, eingerichtet ist. Beispielsweise kann die Schnittstelle 191 dazu eingerichtet sein, mit einem Stecker eines Ladegeräts verbunden zu werden und/oder mit einem Stecker eines Elektrofahrzeuges verbunden zu werden, sodass beispielsweise das verbundene Elektrofahrzeug mit Strom aus der Vielzahl von Batteriezellen 160 versorgt werden kann.

Das System kann beispielsweise einen Leistungsschalter 192 umfassen, welcher zwischen der Schnittstelle 191 und der Vielzahl von Batteriezellen 160 platziert ist, sodass der Leistungsschalter 192 dazu eingerichtet ist, die elektrische Verbindung zwischen der Vielzahl von Batteriezellen 160 und der Schnittstelle 191 zu trennen bzw. zu schließen. Beispielsweise kann der Leistungsschalter 192, wie in Fig. 1e dargestellt, mit den jeweiligen Kontakten 181 und 182 des mindestens einen Blocks 180 einer Mehrzahl von Batteriezellen 160 verbunden sein, wobei der Leistungsschalter 192 über eine Verbindung 146 durch die Steuervorrichtung 140 ansteuerbar ist. Der Leistungsschalter 192 kann beispielsweise ein Relais sein, er kann allerdings auch beispielsweise durch einen Czonka realisiert werden, sodass beispielsweise eine galvanische Trennung zwischen der Schnittstelle 191 und der Vielzahl von Batteriezellen 160 erzielt werden kann.

Somit kann die Steuervorrichtung 140 dazu eingerichtet sein, auf Grundlage des mindestens einen erfassten Parameters für mindestens eine Batteriezelle 160 und/oder auf Grundlage der ermittelten Batteriezustandsinformationen den Leistungsschalter 192 zu trennen, beispielsweise bei einer detektierten Über- oder Unterspannung, und/oder bei einem detektierten Überstrom.

Darüber hinaus kann die Steuervorrichtung 140 auch über eine Verbindung 193 mit der Schnittstelle 191 verbunden sein, wobei über diese Verbindung 193 beispielsweise ein angeschlossenes Ladegerät durch die Steuervorrichtung 140 angesteuert werden kann. So kann beispielsweise die Steuervorrichtung 140 dazu eingerichtet sein, auf Grundlage des mindestens einen erfassten Parameters und/oder der mindestens einen ermittelten Batteriezustandsinformation einen Ladevorgang über die Schnittstelle 191 und ein entsprechend eingerichtetes mit der Schnittstelle 191 verbundenes Ladegerät zu steuern. Diese Verbindung 193 ist jedoch nur optional, es lassen sich auch herkömmliche, nicht steuerbare Ladegeräte an die Schnittstelle 191 anschließen, wobei die Steuervorrichtung 140 dazu eingerichtet ist, einen Ladevorgang mit solch einem herkömmlichen Ladegerät zu überwachen und entsprechend im System zu steuern. Auf weitere Einzelheiten hierzu wird in den folgenden
Ausführungsbeispielen Stellung genommen.

Fig. 2a zeigt eine schematische Darstellung eines Flussdiagramms einer zweiten beispielhaften Ausführungsform eines Verfahrens.

Die Steuervorrichtung 140 ist dazu eingerichtet, zu überprüfen, ob ein kritischer Zustand mindestens einer Batteriezelle 160 vorliegt, wie in Fig. 2a durch Bezugszeichen 210 angedeutet. Ein solcher kritischer Zustand einer Batteriezelle 160 kann beispielsweise auf Grundlage des mindestens einen erfassten Parameters mindestens einer Batteriezelle 160 und/oder der ermittelten Batteriezustandsinformationen von mindestens einer Batteriezelle 160 erfolgen.

Wird ein kritischer Zustand von mindestens einer Batteriezelle festgestellt, so kann beispielsweise die Steuervorrichtung 140 den Leistungsschalter 192 derart ansteuern, dass dieser getrennt wird, sodass die Vielzahl von Batteriezellen 160 beispielsweise von der Schnittstelle 191 galvanisch getrennt werden, wie in Schritt 220 in Fig. 2a gezeigt. Somit kann beispielsweise bei einem Ladevorgang der Vielzahl von Batteriezellen ein kritischer Zustand einer Batteriezelle erkannt werden, beispielsweise ein Überstrom oder eine Überspannung oder eine Übertemperatur, sodass durch Trennen des Leistungsschalters 192 der Ladevorgang unterbrochen werden kann und eine Schädigung der Batteriezellen 160 vermieden werden kann. Beispielsweise kann ein vordefinierter Zeitraum vorgegeben werden, wobei nach Trennen des Leistungsschalters dieser vordefinierte Zeitraum abgewartet wird, und nach Ablauf dieses vordefinierten Zeitraums der Leistungsschalter 192 geschlossen wird, wie in den Schritten 230 und 340 in Fig. 2a exemplarisch dargestellt. Dieser vordefinierte Zeitraum kann beispielsweise in Abhängigkeit der jeweils verwendeten Batteriezellen einige Minuten wie z.B. fünf Minuten, oder zehn Minuten, oder auch nur eine oder zwei Minuten betragen, sodass während dieses vordefinierten Zeitraums kein Ladevorgang erfolgt und sich die jeweiligen vom Ladegerät abgetrennten Batteriezellen erholen können. Nach Schließen des Leistungsschalters wird wiederum geprüft, ob ein kritischer Zustand mindestens einer Batteriezelle vorliegt, d.h. das Verfahren beginnt wieder vorne in Schritt 210. Liegt wiederum ein kritischer Zustand mindestens einer Batteriezelle vor, so erfolgt erneut eine Trennung des Leistungsschalters 192 in Schritt 220. Insbesondere dann, wenn der kritische Zustand wiederum bei der gleichen Batteriezelle 160 wie zuvor festgestellt worden ist, kann beispielsweise der Ladevorgang komplett abgebrochen werden, sodass erst nach einer Benutzereingabe ein erneuter Ladevorgang gestartet werden kann. Das Verfahren kann jedoch wiederum in Schritt 230 fortgesetzt werden, d.h. es kann ein vordefinierter Zeitraum abgewartet werden, so dass nach Ablauf dieses vordefinierten Zeitraums der Leistungsschalter 192 wieder geschlossen wird und das in Fig. 2a dargestellte Verfahren von vorne beginnt.

Die Schritte 220, 230 und 240 in Fig. 2a stellen jedoch nur optionale Schritte dar. Beispielsweise kann das in Fig. 2a dargestellte Verfahren dahingehend abgewandelt werden, dass bei Detektion eines kritischen Zustands einer Batteriezelle 160 in Schritt 210 die Steuervorrichtung 140 eine andere Funktion als das Trennen des Leistungsschalters 192 auslöst. Beispielsweise kann die in Fig. 2a in Schritt 210 dargestellte Überprüfung, ob ein kritischer Zustand mindestens einer Batteriezelle vorliegt, auch eine Überprüfung, ob die Temperatur einer Batteriezelle 160 einen vordefinierten oberen Grenzwert überschreitet, umfassen, wobei bei die Steuervorrichtung 140 dazu eingerichtet sein kann, eine der jeweiligen Batteriezellen 160 zugeordnete Klimatisierungsvorrichtung anzusteuern bzw. zu aktivieren, wenn die Temperatur der dieser Klimatisierungsvorrichtung zugeordneten Batteriezelle 160 den vorgegebenen Grenzwert überschreitet. Beispielsweise kann jeweils eine Klimatisierungsvorrichtung für einen Block 180 von Batteriezellen vorgesehen sein. Die Klimatisierungsvorrichtung kann beispielsweise ein Lüfter sein oder ein aktives Kühlelement darstellen.

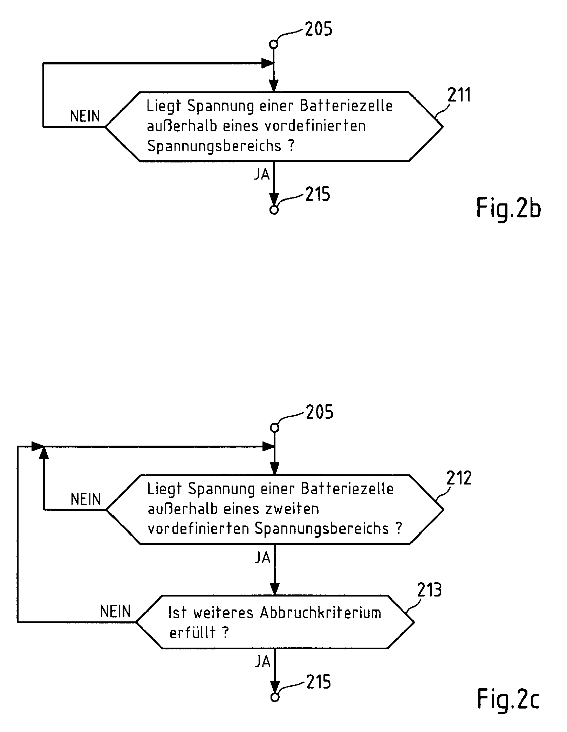

Fig. 2b zeigt eine schematische Darstellung eines Flussdiagramms einer dritten beispielhaften Ausführungsform eines Verfahrens, welche für die Detektion eines kritischen Zustands mindestens einer Batteriezelle des in Fig. 2a dargestellten Verfahrens verwendet werden kann. D.h., dass in Fig. 2b dargestellte Verfahren kann im Flussdiagramm der Fig. 2a zwischen den Bezugszeichen 205 und 215 für den Schritt 210 eingefügt werden. Gemäß dem in Fig. 2b dargestellten Verfahren wird geprüft, ob die Spannung einer Batteriezelle 160 außerhalb eines vordefinierten ersten Spannungsbereiches liegt. Dieser erste Spannungsbereich ist definiert durch einen ersten unteren Grenzwert und einen ersten oberen Grenzwert. Beispielsweise kann der erste untere Grenzwert eine minimale Entladespannung für einen normierten Entladevorgang darstellen und der erste obere Grenzwert kann eine maximale Ladespannung für eine Batteriezelle 160 für einen entsprechenden normierten Ladevorgang darstellen. Beispielsweise kann der normierte Entladevorgang ein 1C Entladevorgang darstellen, es können jedoch auch andere geeignete normierte Entlade- bzw. Ladevorgänge verwendet werden können, wie beispielsweise eine 0,5C oder 0,25C Entladung.

Somit wird der Leistungsschalter 192 getrennt, wenn entweder der erste untere Grenzwert unterschritten wird, beispielsweise wenn ein Elektrofahrzeug mit der Vielzahl von Batteriezellen 160 betrieben wird und die Spannung von mindestens einer Batteriezelle 160 unter den ersten unteren Grenzwert fällt, oder aber der Leistungsschalter 192 wird getrennt, wenn die Spannung einer Batteriezelle 160 oberhalb des ersten oberen Grenzwertes liegt, beispielsweise während eines Ladevorgangs.

Fig. 2c zeigt eine schematische Darstellung einer vierten beispielhaften Ausführungsform eines Verfahrens, welches für die in Fig. 2a in Schritt 210 dargestellte Überprüfung, ob ein kritischer Zustand mindestens einer Batteriezelle vorliegt, verwendet werden kann.

In Schritt 212 wird geprüft, ob die Spannung einer Batteriezelle außerhalb eines zweiten vordefinierten Spannungsbereichs liegt. Dieser zweite vordefinierte Spannungsbereich wird definiert durch einen zweiten unteren Grenzwert und einen zweiten oberen Grenzwert, wobei der zweite untere Grenzwert beispielsweise oberhalb des ersten oberen Grenzwertes und der zweite obere Grenzwert beispielsweise unterhalb des ersten oberen Grenzwertes liegt. Für diesen beispielhaften Fall liegt dementsprechend der zweite vordefinierte Spannungsbereich innerhalb des ersten vordefinierten Spannungsbereiches.

Wird festgestellt, dass die Spannung einer Batteriezelle 160 außerhalb dieses zweiten vordefinierten Spannungsbereichs liegt, so wird geprüft, ob ein weiteres Abbruchkriterium erfüllt ist, wie im Schritt 213 in Fig. 2c dargestellt. Dieses weitere Abbruchkriterium kann beispielsweise das Abwarten eines vordefinierten Zeitraums umfassen, und das nachfolgende Überprüfen, ob nach Ablauf dieses vorgegebenen Zeitraums die Spannung der jeweiligen Batteriezelle weiterhin außerhalb des zweiten vordefinierten Spannungsbereichs liegt. Nur dann, wenn die Spannung der jeweiligen Batteriezelle weiterhin außerhalb dieses zweiten vordefinierten Spannungsbereichs liegt, wird das Verfahren mit dem Trennen des Leistungsschalters 192 in Schritt 220, wie in Fig. 2a dargestellt, fortgesetzt. Anderenfalls beginnt das Verfahren wieder von vorne und überprüft, ob die Spannung einer Batteriezelle der Vielzahl von Batteriezellen 160 außerhalb des zweiten vordefinierten Spannungsbereichs liegt, d.h. das Verfahren beginnt wieder bei Schritt 212. Hierdurch kann beispielsweise vermieden werden, dass bei einem tiefen Ladezustand eine starke Belastung mit einem einhergehenden Abfall einer Batteriezellenspannung unterhalb des zweiten unteren Grenzwertes zu einem frühzeitigen Abschalten führt.

Beispielsweise kann das Überprüfen, ob das weitere Abbruchkriterium erfüllt ist, das Prüfen, ob eine vordefinierte Lastspitze überschritten wird, umfassen. Beispielsweise kann in Schritt 213 eine Verlustleistung bestimmt werden, wobei erst bei Überschreiten eines Grenzwertes durch diese bestimmte Verlustleistung das weitere Abbruchkriterium erfüllt ist. Dies kann beispielsweise durch das Ermitteln eines $(i^2)*t$-Wertes, d.h. der Bildung eines Integrals über den Stromquadratwert, wobei der Strom dem Strom entspricht, welcher der jeweiligen Batteriezelle, die eine Spannung außerhalb des zweiten vordefinierten Spannungsbereichs aufweist, entspricht. Somit sind bis zum Erreichen dieses Grenzwertes für eine Verlustleistung auch Spannungen außerhalb des zweiten vordefinierten Spannungsbereichs erlaubt, d.h. eine Abschaltung durch den Leistungsschalter 192 erfolgt erst dann, wenn in Schritt 213 festgestellt wird, dass der Grenzwert für die Verlustleistung überschritten wird. Die Verlustleistung wird somit erst dann berechnet, wenn in Schritt 212 festgestellt worden ist, dass die Spannung einer Batteriezelle außerhalb des zweiten vordefinierten Spannungsbereichs liegt. Beispielsweise können aber auch andere weitere Abbruchkriterien für den Schritt 213 in Fig. 2c verwendet werden, es können auch Kombinationen von weiteren Abbruchkriterien eingesetzt werden.

Die in Fig. 2b dargestellte Überprüfung des dort genannten vordefinierten Spannungsbereichs, im Folgenden erster vordefinierter Spannungsbereich bezeichnet, und die in Fig. 2c dargestellte Überprüfung des zweiten vordefinierten Spannungsbereichs können auch miteinander kombiniert werden. Beispielsweise kann die Überprüfung gemäß Fig. 2b von einem ersten Schaltkreis vorgenommen werden und die Überprüfung, ob die Spannung einer Batteriezelle außerhalb eines zweiten vordefinierten Spannungsbereichs und das weitere Abbruchkriterium erfüllt ist, d.h. gemäß der Darstellung in Fig. 2c, kann von einem zweiten Schaltkreis vorgenommen werden, wobei diese beiden Schaltkreise unabhängig von einander sind. Einer dieser beiden Schaltkreise kann durch die Steuervorrichtung 140 realisiert werden. Somit kann durch diese beispielhafte Trennung der Schaltkreise eine erhöhte Sicherheit durch die vorhandene Redundanz erzielt werden.

Die in Fig. 2a in Schritt 210 dargestellte Überprüfung, ob ein kritischer Zustand mindestens einer Batteriezelle vorliegt, kann beispielsweise auch eine Überprüfung, ob die Temperatur einer Batteriezelle 160 einen vordefinierten unteren Grenzwert unterschreitet und oder einen vordefinierten oberen Grenzwert überschreitet, umfassen. Beispielsweise kann somit ein Ladevorgang unterbunden werden, wenn die Temperatur mindestens einer Batteriezelle 160 unter den vordefinierten Grenzwert fällt, der beispielsweise 5°C oder 0°C betragen kann, allerdings auch hiervon abweichen kann. Somit kann vermieden werden, dass Batteriezellen 160 bei zu tiefen Temperaturen geladen werden. Somit kann beispielsweise bei Lithium-Ionen Batterien verhindert werden, dass es zur Ablagerung von Lithiummetall an der Anode kommt, was schlussendlich zur Einschränkung der Sicherheit der jeweiligen Batteriezelle führen könnte. Gleichzeitig kann ein Schutz vor Überhitzung durch Prüfen, ob die Temperatur einer Batteriezelle oberhalb des oberen Grenzwertes liegt, erfolgen. Dieser obere Grenzwert kann beispielsweise 45°C oder 50°C betragen, aber auch hiervon abweichen.

Das Ermitteln von Batteriezustandsinformationen für mindestens eine Batteriezelle 160 der Vielzahl von Batteriezellen 160 kann das Ermitteln einer Information über den Ladezustand einer Batteriezelle 160 umfassen.

Die Steuervorrichtung 140 kann dazu eingerichtet, eine Information über den Ladezustand jeder beliebigen Batteriezelle 160 auf Grundlage der erfassten Parameter zu ermitteln. Die Information über den Ladezustand kann beispielsweise von der Steuervorrichtung 140 an der Ausgabemittel 155 ausgegeben werden, und/oder sie kann zur Steuerung eines Lade- oder Entladevorgangs der Vielzahl von Batteriezellen 160 verwendet werden.

Die Information über den Ladezustand der jeweiligen Batteriezelle 160 kann mindestens einen der folgenden Werte umfassen: absoluter Ladezustand; normierter Ladezustand; und ein auf einen eingeschränkten Kapazitätsbereich abgebildeter Ladezustand.

Der absolute Ladezustand für eine Batteriezelle 160 kann beispielsweise durch Integration des Stroms der jeweiligen Batteriezelle 160 ermittelt werden, d.h. der absolute Ladezustand stellt ein Maß für aufgenommene Ladung der jeweiligen Batteriezelle 160 dar. Beispielsweise kann der absolute Ladezustand in Amperestunden (Ah) angegeben werden. Dieser durch Integration des Stroms ermittelte absolute Ladezustand wird im folgenden als absoluter, unkorrigierter Ladezustand bezeichnet. Bei einem positiven Strom durch die Batteriezelle 160, d.h. bei einem Ladevorgang, nimmt der absolute, unkorrigierte Ladezustand zu, und bei einem negativen Strom durch die Batteriezelle 160, d.h. bei einem Entladevorgang, nimmt der absolute, unkorrigierte Ladezustand ab.

Der absolute Ladezustand kann auch ein absoluter, korrigierter Ladezustand sein, welcher sich vom absoluten, unkorrigierten Ladezustand darin unterscheidet, dass zusätzlich die Reduktion der zur Verfügung stehenden Ladungsmenge (Ah) in Funktion des Ladestromes und der Temperatur berücksichtigt wird. Hierzu können beispielsweise Korrekturfaktoren bestimmt werden und die pro Zeiteinheit entnommene bzw. zugeführte Ladungsmenge entsprechend korrigiert werden. Diese Korrekturfaktoren können beispielsweise auf Grundlage von Messungen und/oder theoretischen Modellen für jeden Batteriezellentyp bestimmt werden, wobei die gegenseitige Beeinflussung von Temperatur und Strom berücksichtigt werden kann. Beispielsweise kann eine zweidimensionale Korrekturmatrix erstellt werden, die einen Korrekturfaktor für jeweils einen Temperaturwert und einen Stromwert ausgibt. Es können jeweils verschiedene Korrekturfaktoren für einen Lade- und einen Entladevorgang bestimmt werden. Als Referenzladungsmenge für die Korrekturfaktoren kann beispielsweise die Ladungsmenge für eine normierte Entladung bei einer bestimmten Raumtemperatur gelten, wie beispielsweise eine 1C Entladung und eine 25°C Raumtemperatur. Die normierter Entladung und die Raumtemperatur können abhängig vom Einsatzzweck der Vielzahl von Batteriezellen 160 frei ausgewählt werden.

Beispielsweise kann somit der absolute, korrigierte Ladezustand für eine Batteriezelle 160 wie folgt ermittelt werden: Integration über den Strom über einen Zeitraum, in welchem der Strom näherungsweise konstant ist, zur Ermittlung der zugeführten bzw. entnommenen Ladungsmenge während dieses Zeitraums; Ermitteln des Korrekturfaktors in Abhängigkeit des Stroms und der Temperatur während dieses Zeitraums; und Gewichtung der zugeführten bzw. entnommenen Ladungsmenge mit dem ermittelten Korrekturfaktor und Addieren dieser gewichteten Ladungsmenge zum absoluten, korrigierten Ladezustand der jeweiligen Batteriezelle 160. Alternativ kann auch während der Integration über den Stromwert eine Gewichtung des Stromwerts mit einem aktuell ermittelten Korrekturwert in Abhängigkeit des aktuellen Stroms und der aktuell für die jeweilige Batteriezelle 160 ermittelten Temperatur erfolgen. Die Gewichtung kann beispielsweise eine Multiplikation darstellen.

Darüberhinaus kann auch die erfasste Spannung einer Batteriezelle in die Ermittlung des absoluten Ladezustands einfließen. So kann beispielsweise der absolute Ladezustand, sowohl unkorrigiert als auch korrigiert, auf 0 gesetzt werden, wenn die Spannung der jeweiligen Batteriezelle 160 unter einen vordefinierten unteren Grenzwert fällt, beispielsweise unter den zuvor erläuterten unteren ersten oder zweiten Grenzwert.

Der normierte Ladezustand kann beispielsweise auf Grundlage einer der zuvor erläuterten absoluten Ladezustände ermittelt werden, wobei beispielsweise einer der absoluten Ladezustände auf einen Wertebereich zwischen 0 und 1 normiert werden kann, wobei 0 einer vollkommen entladenen Batteriezelle 160 und 1 einer komplett geladenen Batteriezelle 160 entspricht, oder einer der absoluten Ladezustände kann beispielsweise auf einen prozentualen Wertebereich zwischen 0% und 100% normiert werden.

Darüberhinaus kann die Information über den Ladezustand der jeweiligen Batteriezelle 160 auch einen auf einen eingeschränkten Kapazitätsbereich abgebildeten Ladezustand umfassen. Dieser auf einen eingeschränkten Kapazitätsbereich abgebildete Ladezustand, im folgenden stets als abgebildeter Ladezustand bezeichnet, kann auf jedem der zuvor erläuterten absoluten oder normierten Ladezustände basieren.

Der abgebildete Ladezustand kann beispielsweise auf einen vordefinierten Kapazitätsbereich einer Batteriezelle abgebildet sein, welcher beispielsweise kleiner als der nutzbare Kapazitätsbereich der Batteriezelle 160 ist. Dieser nutzbare Kapazitätsbereich kann beispielsweise der nutzbare Kapazitätsbereich einer neuen Batteriezelle 160 darstellen und somit die Ausgangskapazität einer Batteriezelle 160 darstellen.

Beispielsweise kann der abgebildete Ladezustand L' wie folgt in Abhängigkeit eines normierten oder absoluten Ladezustands L ermittelt werden, wobei $L_1$ eine untere Kapazitätsgrenze und $L_2$ eine obere Kapazitätsgrenze innerhalb des nutzbaren Kapazitätsbereichs darstellt, so dass der normierte bzw. absolute Ladezustand L auf den durch $L_1$ und $L_2$ vordefinierten Kapazitätsbereich abgebildet wird:

$$L' = \begin{cases} 0 & \text{für} & L < L_1 \\ \dfrac{L - L_1}{L_2 - L_1} & \text{für} & L_1 \leq L \leq L_2 \\ 1 & \text{für} & L > L_2 \end{cases}$$

L' kann beispielsweise auch in eine Prozentdarstellung umgewandelt werden, d.h. Werte zwischen 0% und 100% proportional zum oben angegebenen L' annehmen.

Beispielsweise kann die untere Kapazitätsgrenze $L_1$ auf einen Wert zwischen 5% und 25%, beispielsweise 15%, insbesondere 10%, einer Ausgangsnennkapazität der Batteriezelle 160 gesetzt werden, und die obere Kapazitätsgrenze $L_2$ kann beispielsweise auf einen Wert zwischen 75% und 95%, beispielsweise 85%, insbesondere 90%, einer Ausgangsnennkapazität der Batteriezelle 160 gesetzt werden. Die Differenz zwischen $L_2$ und $L_1$ kann als Nutzanteil der Kapazität bezeichnet werden. Dieser Nutzanteil der Kapazität kann in Abhängigkeit der Applikation gewählt werden. So kann in Applikationen, in denen die Lebensdauer eine besonders große Rolle spielt, der Nutzanteil der Kapazität in Bezug auf die Ausgangsnennkapazität kleiner gewählt werden (z.B. für eine Lebensdauer von 10 Jahren ein Anteil von 70.85% der Ausgangsnennkapazität), in Applikationen mit reduzierten Anforderungen (z.B. weniger als 5 Jahre Lebensdauer) kann der Nutzanteil der Kapazität in Bezug auf die Ausgangsnennkapazität größer gewählt werden, wie beispielsweise zwischen 80 und 95%.

Beispielsweise können die untere Kapazitätsgrenze $L_1$ und die obere Kapazitätsgrenze $L_2$ derart gewählt werden, dass der abgebildete Bereich zwischen $L_1$ und $L_2$ annähernd oder exakt symmetrisch um den Wert von 50% der aktuell nutzbaren Kapazität liegt. $L_1$ und $L_2$ können somit abhängig von der aktuell nutzbaren Kapazität nachgeführt werden. Diese aktuelle nutzbare Kapazität kann für die jeweilige Batteriezelle 160 ermittelt werden und kann abhängig sein von der Ausgangsnennkapazität der Batteriezelle 165 ermittelt werden, wobei diese Ausgangsnennkapazität beispielsweise in Abhängigkeit des Alters der Batterie und/oder Anzahl der Lade- und/oder Entladezyklen und/oder weiterer Informationen über den Gesundheitszustand der Batteriezelle reduziert werden kann. Auf diese weiteren Informationen über den Gesundheitszustand wird später genauer eingegangen. Als Grundlage für die Ermittlung der aktuellen zur Verfügung stehenden Kapazität, d.h. der aktuellen nutzbaren Kapazität, können beispielsweise Lebensdauertestkurven, die auf Entlade- und Ladezyklen mit konstantem Strom, z.B. 1C und konstanter Entladetiefe beruhen, beispielweise 80%. Diese Ermittlung der aktuell zur Verfügung stehenden Kapazität kann unabhängig für mindestens eine Batteriezelle der Vielzahl von Batteriezellen durchgeführt werden und ist nicht nur in Kombination mit der Ermittlung des abgebildeten Ladezustands offenbart.

Die Differenz zwischen $L_2$ und $L_1$ kann beispielsweise konstant gehalten werden, d.h. abgebildete Kapazitätsbereich bleibt absolut gesehen gleich, und nimmt damit bei einer kleiner werdenden aktuell nutzbaren Kapazität prozentual einen immer größer werdenden Kapazitätsbereich ein.

Die Differenz zwischen $L_2$ und $L_1$ kann aber beispielsweise auch so von der aktuell nutzbaren Kapazität abhängen, dass der durch diese Differenz abgebildete Kapazitätsbereich prozentual immer gleich oder annähernd gleich zur aktuell nutzbaren Kapazität ist. Dies kann beispielsweise dann vorteilhaft sein, wenn zu Beginn ein relativ großer Bereich der Ausgangsnennkapazität als nutzbare Kapazität definiert wird.

Beispielsweise kann bei einer Referenzladung nach Erreichen eines 100%-Wertes für den abgebildeten Ladezustand weitergeladen werden, beispielsweise bis die aktuell nutzbare Kapazität für die jeweilige Batteriezelle annähernd oder genau die aktuell nutzbare Kapazität erreicht hat.

Darüberhinaus kann das Ermitteln von Batteriezustandsinformationen für mindestens eine Batteriezelle 160 der Vielzahl von Batteriezellen 160 Ermitteln einer Information über den Ladezustand der Vielzahl der Batteriezellen 160, d.h. es kann eine Information über den Ladezustand des durch die Vielzahl der Batteriezellen 160 gebildeten Batteriepacks ermittelt werden. Somit kann aus dieser Information auf den Gesamtladezustand des Batteriepacks, welche die Vielzahl von Batteriezellen 160 umfasst, geschlossen werden.

Beispielsweise kann die Information über den Ladezustand der Vielzahl der Batteriezellen 160 mindestens einen der folgenden Werte umfassen: absoluter Ladezustand; normierter Ladezustand; und ein auf einen eingeschränkten Kapazitätsbereich abgebildeter Ladezustand.

Der absolute Ladezustand der Vielzahl von Batteriezellen 160 kann beispielsweise durch Addition der jeweiligen absoluten Ladezustände der jeweiligen Batteriezellen 160 der Vielzahl von Batteriezellen 160 ermittelt werden. Der normierte Ladezustand der Vielzahl von Batteriezellen 160 kann beispielsweise in Abhängigkeit des absoluten Ladezustands der Vielzahl von Batteriezellen 160 ermittelt werden, analog zu der erläuterten Ermittlung eines normierten Ladezustands für jeweils eine Batteriezelle 160. Der auf einen eingeschränkten Kapazitätsbereich abgebildete Ladezustand der Vielzahl von Batteriezellen 160 kann beispielsweise in Abhängigkeit des absoluten Ladezustands oder eines normierten Ladezustands der Vielzahl von Batteriezellen 160 ermittelt werden, analog zur der erläuterten Ermittlung eines auf einen eingeschränkten Kapazitätsbereich abgebildeten Ladezustands für eine einzelne Batteriezelle 160.

Beispielsweise kann ein abgebildeter Ladezustand für die Vielzahl von Batteriezellen 160 gebildet werden. Dieser abgebildete Ladezustand kann beispielsweise über die Ausgabemittel an einen Benutzer angegeben werden. Weist beispielsweise ein Batteriepack mit der Vielzahl von Batteriezellen 160 eine Ausgangsnennkapazität von 130Ah auf, so kann beispielsweise $L_1$ auf 10% der Ausgangsnennkapazität gesetzt werden, d.h. auf 13 Ah, und beispielsweise $L_2$ auf 90% der Ausgangsnennkapazität gesetzt werden, d.h. auf 117 Ah. Der abgebildete Kapazitätsbereich beträgt somit 80% der anfangs Ausgangsnennkapazität. Die Differenz zwischen $L_2$ und $L_1$ kann beispielsweise konstant gehalten werden. Diese Differenz kann als Nutzanteil der Kapazität bezeichnet werden. Nimmt nun die aktuell nutzbare Kapazität nach mehreren Lade- und Entladezyklen ab, so wird der Nutzanteil der Kapazität in Bezug auf die aktuell verfügbare Kapazität immer größer. Stehen beispielsweise nach vielen Zyklen nur noch 117Ah aktuell nutzbare Kapazität für das Batteriepack zur Verfügung, so stehen immer noch 104 Ah als Nutzanteil der Kapazität zur Verfügung, wobei beispielsweise durch die zuvor erläuterte Symmetrierung $L_1$=6,5Ah und $L_2$=110,5Ah gilt. Ein Benutzer hat aber immer noch das Gefühl, dass er so viel Energie aus dem Batteriepack ziehen kann, wie am ersten Tag. Eine Reduktion der Batteriepackkapazität wird somit erst spürbar, wenn die aktuell nutzbare Kapazität den Nutzanteil der Kapazität unterschreitet. Die Differenz zwischen $L_2$ und $L_1$ kann aber beispielsweise auch so von der aktuell nutzbaren Kapazität abhängen, dass der durch diese Differenz abgebildete Kapazitätsbereich prozentual immer gleich oder annähernd gleich zur aktuell nutzbaren Kapazität ist.

Die Information über den Ladezustand der Vielzahl der Batteriezellen 160 kann beispielsweise von der Steuereinrichtung 140 über die Ausgabemittel 155 ausgegeben worden. Somit kann ein Benutzer über den Gesamtladezustand des die Vielzahl von Batteriezellen 160 umfassenden Batteriepacks informiert werden.

Beispielsweise kann die Steuervorrichtung 140 dazu eingerichtet sein, eine Referenzladung der Vielzahl von Batteriezellen 160 durchzuführen. Bei dieser Referenzladung wird beispielsweise jede Batteriezelle 160 der Vielzahl von Batteriezellen 140 durch ein vordefiniertes Ladeverfahren bis annähernd an die noch zur Verfügung stehende Nennkapazität der jeweiligen Batteriezelle 160 geladen. Anschließend kann beispielsweise der Wert für den absoluten Ladezustand für jede der geladenen Batteriezellen 160 auf den jeweiligen Wert der noch zur Verfügung stehenden Nennkapazität der jeweiligen Batteriezelle 160 gesetzt werden.

Beispielsweise kann dieser Referenzladung durch eine Volladung der Batteriezellen 160 bis zu einer vordefinierten Ladeentspannung erfolgen.

Die Referenzladung kann aber beispielsweise auch ein mehrstufiges Ladeverfahren umfassen, bei der beispielsweise zunächst eine Ladung der einzelnen Batteriezellen 160 mit einem konstanten Strom und anschließend eine Ladung mit einer konstanten Spannung bis zu einem vordefinierten Restladestrom erfolgt. Dieser vordefinierte Restladestrom kann beispielsweise zwischen 1 und 5 % der Nominalkapazität/h betragen, wie beispielsweise 5%, 3% oder 1%.

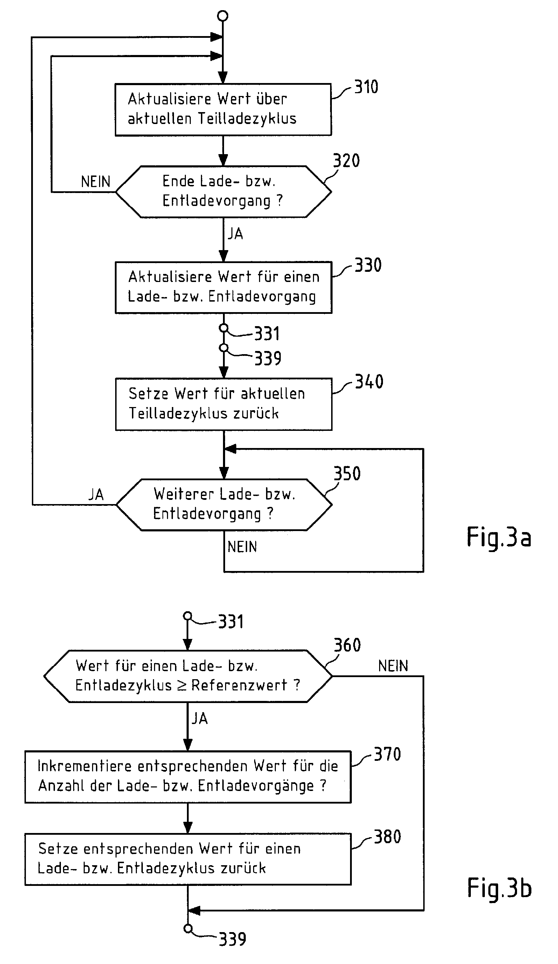

Fig. 3a zeigt eine schematische Darstellung eines Flussdiagramms einer sechsten beispielhaften Ausführungsform eines Verfahrens. Dieses Verfahren wird zur Ermittlung einer Information über die Anzahl der Lade- und/oder Entladezyklen einer jeweiligen Batteriezelle 160 verwendet.

Die Information über die Anzahl der Lade- und/oder Entladezyklen der jeweiligen Batteriezelle 160 umfasst einen Wert über einen aktuellen Teilladezyklus, welcher ein Maß für die der jeweiligen Batteriezelle 160 entnommenen bzw. zugeführte Ladung während eines Lade- bzw. eines Entladevorgangs darstellt. Der Wert über einen aktuellen Teilladezyklus einer Batteriezelle 160 basiert auf dem Integral des Lade- bzw. Entladestroms seit dem letzten Wechsel zwischen einem Entlade- bzw. Ladevorgang. So wird, wie in Fig. 3a dargestellt, nach Beginn eines Lade- bzw. Entladevorgangs der Wert über den aktuellen Teilladezyklus einer jeweiligen Batteriezelle 160 solange aktualisiert, bis dieser Lade- bzw. Entladevorgang beendet wird, wie durch die Bezugszeichen 310 und 320 in Fig. 3a darstellt. Dieses Aktualisieren des Werts über dem aktuellen Teilladezyklus während des Schritts 310 bis zur Beendigung des jeweiligen Lade- bzw. Entladevorgangs kann beispielsweise auf Grundlage eines während dieses Entlade- bzw. Ladevorgangs ermittelten absoluten Ladezustands erfolgen, wobei beispielsweise zu Beginn des Lade- bzw. Entladevorgangs der jeweilige absolute Ladezustand der Batteriezelle 160 gespeichert wird, und nachfolgend während des Entlade- bzw. Ladevorgangs der absolute Ladezustand aktualisiert wird, sodass am Ende des Lade- bzw. Entladevorgangs, d.h. bei Erreichen des Schritts 320 und feststellen, dass das Ende des Lade- bzw. Entladevorgangs vorliegt, der vorher gespeicherte Wert des absoluten Ladezustands von nunmehr aktualisierten Wert des absoluten Ladezustands abgezogen wird, d.h. der entsprechend ermittelte Wert über den aktuellen Teilladezyklus entspricht der Differenz aus dem zuvor gespeichertem absoluten Ladezustand und den am Ende des Ladevorgangs bzw. Entladevorgangs ermittelten absoluten Ladezustands für die jeweilige Batteriezelle 160. Für einen Entladevorgang ist das Vorzeichen des aktuellen Teilladezyklus negativ, während für einen Ladevorgang das Vorzeichen des aktuellen Teilladezyklus positiv definiert ist. Das Aktualisieren des Werts über den aktuellen Teilladezyklus in Schritt 310 kann jedoch auch unabhängig von einer Ermittlung des Ladezustands erfolgen, d.h. durch eine separate Integration über den Ladestrom bzw. Entladestrom der jeweiligen Batteriezelle 160, wobei optional auch ein Korrekturfaktor, welcher in Abhängigkeit des Ladestrom und/oder der Temperatur zur Gewichtung des Integrals über den Lade- bzw. Entladestrom verwendet werden kann, wie zuvor bereits erläutert.

Die Information über die Anzahl der Lade- und/oder Entladezyklen der jeweiligen Batteriezelle 160 kann auch einen Wert für einen Ladezyklus und einen Wert für einen Entladezyklus umfassen. Wurde beispielsweise in Schritt 320 festgestellt, dass ein Ende eines Lade- bzw. Entladevorgangs vorliegt, so kann nachfolgend der entsprechende Wert für entweder einen Ladevorgang oder für ein Entladevorgang in Abhängigkeit davon, ob vorher ein Ladevorgang oder ein Entladevorgang beendet wurde, aktualisiert werden. Wurde beispielsweise ein Ladevorgang beendet, so kann der vorher ermittelte Wert über den aktuellen Teilladezyklus auf den Wert für einen Ladezyklus der jeweiligen Batteriezelle 160 aufaddiert werden. Dieses Aufaddieren kann beispielsweise vorab eine Gewichtung des jeweiligen Werts über den aktuellen Teilladezyklus der jeweiligen Batteriezelle 160 mit einem Faktor umfassen, wobei beispielsweise ein Wert über einen aktuellen Teilladezyklus, der annähernd 100 Prozent der Norminalkapazität der jeweiligen Batteriezelle 160 entspricht, mit einem Faktor 1 gewichtet wird, während kleinere Teilladezyklen, welche nur einen geringeren Prozentsatz der Norminalkapazität entsprechen, mit einem geringeren Faktor, d.h. zwischen 0 und 1 gewichtet werden. Darüber hinaus kann auch beispielsweise eine Gewichtung des Werts über den aktuellen Teilladezyklus auf Grundlage der zeitlichen Dauer des jeweiligen Entlade- bzw. Ladevorgangs erfolgen. So kann beispielsweise der Wert über den aktuellen Teilladezyklus zusätzlich durch die Dauer des jeweiligen Entlade- bzw. Ladevorgangs dividiert werden. Es können auch noch weitere Algorithmen zur Stromgewichtung während der Aktualisierung des Werts über den aktuellen Teilladezyklus verwendet werden.

Somit kann in Schritt 330 entweder der Wert für den Ladevorgang oder der Wert für den Entladevorgang auf Grundlage des ermittelten Werts über den aktuellen Teilladezyklus aktualisiert werden, wobei diese Aktualisierung durch Aufaddieren eines auf dem Wert über den aktuellen Teilladezyklus basierenden Werts auf den jeweiligen Wert für einen Ladezyklus bzw. auf den jeweiligen Wert für einen Entladezyklus erfolgt. Dieser auf dem Wert über den aktuellen Teilladezyklus basierender Wert kann der Wert über den aktuellen Teilladezyklus darstellen, oder einer der zuvor beschriebenen gewichteten Werte über den aktuellen Teilladezyklus darstellen.

Nachfolgend wird der Wert für den aktuellen Teilladezyklus der jeweiligen Batteriezelle 160 zurückgesetzt, wie in Fig. 3a durch Bezugszeichen 340 angedeutet. Sobald ein weiterer Lade- bzw. Entladevorgang beginnt, so startet das in Fig. 3a gezeigte Verfahren erneut mit dem Aktualisieren des Werts über den aktuellen Teilladezyklus der jeweiligen Batteriezelle 160, bis dieser neu gestartete Lade- bzw. Entladevorgang beendet wird, wie in den Schritten 350, 310 und 320 in Fig. 3a dargestellt.

Fig. 3b zeigt eine schematische Darstellung eines Flussdiagramms einer siebten beispielhaften Ausstellungsform eines Verfahrens. Dieses in Fig. 3b dargestellte Verfahren kann als Erweiterung für das in Fig. 3a dargestellte Verfahren betrachtet werden, wobei dieses siebte beispielhafte Verfahren an die durch die Bezugszeichen 331 und 339 in Fig. 3a gekennzeichneten Positionen des Verfahrens in Fig. 3a eingefügt werden kann.

In Schritt 360 wird überprüft, ob der in Schritt 330 aktualisierte Wert für einen Lade- bzw. Entladevorgang einen Referenzwert erreicht oder überschreitet. Dieser Referenzwert kann beispielsweise der Wert der verfügbaren, nominalen Kapazität der jeweiligen Batteriezelle 160 darstellen, welcher wiederum von der jeweiligen Lebensdauer der Batteriezelle 160 abhängig sein kann. Dieser Referenzwert kann jedoch auch durch einen anderen, geeigneten Kapazitätswert bestimmt werden. Wurde beispielsweise in Schritt 330 der Wert für einen Ladevorgang aktualisiert, so wird in Schritt 360 überprüft, ob dieser Wert für einen Ladevorgang größer oder gleich dem Referenzwert liegt. Umgekehrt wird in Schritt 360 überprüft, ob der Wert für einen Entladezyklus gleich oder größer dem Referenzwert ist, wenn in Schritt 330 der Wert für einen Entladevorgang aktualisiert worden ist.

Wurde in Schritt 360 festgestellt, dass der Referenzwert entweder erreicht oder überschritten wurde, so wird entweder der Wert für die Anzahl der Ladevorgänge inkrementiert oder der Wert für die Anzahl der Entladevorgänge inkrementiert, wie in Bezugszeichen 370 in Fig. 3b dargestellt. Somit kann beispielsweise jeder Batteriezelle 160 jeweils ein Wert für die Anzahl der Ladevorgänge und ein Wert für die Anzahl der Entladevorgänge zugeordnet werden, welche jeweils dann inkrementiert werden, wenn der Wert entweder des Ladezyklus für die jeweilige Batteriezelle größer gleich dem Referenzwert liegt, oder der Wert für den Entladezyklus der jeweiligen Batteriezelle 160 größer gleich den Referenzwert liegt. Anschließend wird in Schritt 380 der entsprechende Wert für einen Ladezyklus bzw. für einen Entladezyklus zurückgesetzt.

Somit kann beispielsweise jeder der Vielzahl von Batteriezellen 160 jeweils ein Wert für einen Ladevorgang und ein Wert für einen Entladevorgang zugeordnet werden, welcher gemäß dem in Fig. 3a dargestellten Verfahren aktualisiert werden kann, und es kann mit dem in Fig. 3b dargestellten Verfahren überwacht werden, wie viele äquivalente Vollastentladezyklen bzw. wie viele äquivalente Volllastladezyklen bei einer entsprechenden Batteriezelle 160 durchgeführt worden sind. Diese Anzahl der äquivalenten Volllastzyklen stellen ein Maß für das Alter der jeweiligen Batteriezellen 160 dar. In Bezug auf das in Fig. 3b dargestellte beispielhafte siebte Verfahren, kann auch in Schritt 380 ein Zurücksetzen beider Werte für einen Lade- bzw. Entladezyklus der jeweiligen Batteriezelle 160 erfolgen.

Wie bereits erläutert, kann die Steuervorrichtung 140 dazu eingerichtet sein, auf Grundlage der ermittelten Batteriezustandsinformationen beispielsweise einen Ladevorgang und/oder Entladevorgang der Vielzahl von Batteriezellen 160 zu steuern bzw. zu regeln.

Wird beispielsweise an die Schnittstelle 191 ein von der Steuervorrichtung 140 steuerbares Ladegerät angeschlossen, welches über die Verbindung 193 angesteuert werden kann, so kann beispielsweise die Steuervorrichtung 140 den Ladestrom des steuerbaren Ladegeräts in Abhängigkeit der ermittelten Batteriezustandsinformation steuern bzw. regeln. So kann beispielsweise bei Detektion eines kritischen Zustands in Schritt 210 des in Fig. 2a dargestellten beispielhaften Verfahrens das steuerbare Ladegerät von der Steuervorrichtung 140 derart angesteuert werden, dass der Ladestrom des Ladegeräts auf 0 heruntergeregelt wird. Dafür kann beispielsweise das Trennen des Leistungsschalters in Schritt 220 entfallen, d.h. der Schritt 220 in Fig. 2a kann durch ein Steuern des Ladestroms des Ladegeräts auf 0 ersetzt werden. Entsprechend kann der Schritt 240, d.h. das Schließen des Leistungsschalter, durch ein Steuern das Ladestroms des Ladegeräts auf einen vorgebbaren Ladestrom >0 ersetzt werden. Alternativ kann der Leistungsschalter 192 weiterhin parallel zur entsprechenden Ansteuerung des Ladegeräts getrennt bzw. geschlossen werden, wie in den Schritten 220 und 240 in Fig. 2a vorgesehen.

Die Steuervorrichtung 140 kann beispielsweise dazu eingerichtet sein, den Ladestrom für mindestens eine Batteriezelle 160 der Vielzahl von Batteriezellen 160 während eines Ladevorgangs auf Grundlage der ermittelten Batteriezustandsinformationen abzusenken.

Dieses Absenken des Ladestroms kann beispielsweise durch die Ansteuerung eines steuerbaren Ladegeräts erfolgen und/oder aber durch das Einschalten mindestens eines schaltbaren Ausgleichselements 510, wobei jedes der schaltbaren Ausgleichselemente 510 einer Batteriezelle 160 zugeordnet ist und dazu eingerichtet ist, einen Bypasspfad parallel zu der jeweiligen Batteriezelle ein- bzw. auszuschalten. So kann beispielsweise, wenn für eine Batteriezelle 160 ein kritischer Zustand detektiert wird, der Ladestrom für diese Batteriezelle 160 abgesenkt werden.

Beispielsweise kann die Steuervorrichtung 140 dazu eingerichtet sein, zu prüfen, ob die Spannung einer Batteriezelle der Vielzahl von Batteriezellen 160 während eines Ladevorgangs einen vordefinierten Grenzwert erreicht, und nach Erreichen dieses Grenzwertes ein an die Schnittstelle 191 angeschlossenes steuerbares Ladegerät derart anzusteuern, dass der von dem Ladegerät bereitgestellte Ladestrom derart abgesenkt wird, dass die Spannung an dieser Batteriezelle während des Ladevorgangs konstant auf dem vordefinierten Grenzwert gehalten wird. Somit kann der Ladestrom dauernd reduziert werden und die Spannung über dieser Batteriezelle 160 konstant auf dem vordefinierten Grenzwert gehalten werden. Beispielsweise kann der Ladestrom für jeden einzelnen Block 180 von Batteriezellen 160 steuerbar sein, somit kann für jeder Batteriezelle 160 eines Blocks 180 geprüft werden, ob der vordefinierte Grenzwert erreicht wird, und bei Erreichen des Grenzwertes kann die Steuervorrichtung 140 das Ladegerät derart ansteuern, dass der Ladestrom für den entsprechenden Block derart abgesenkt wird, dass die Spannung an dieser Batteriezelle des Blocks 180 während des Ladevorgangs konstant auf dem vordefinierten Grenzwert gehalten wird. Der vordefinierte Grenzwert kann beispielsweise die Ladeentspannung einer Batteriezelle 160 sein, die vom jeweiligen Typ der Batteriezelle 160 abhängt.

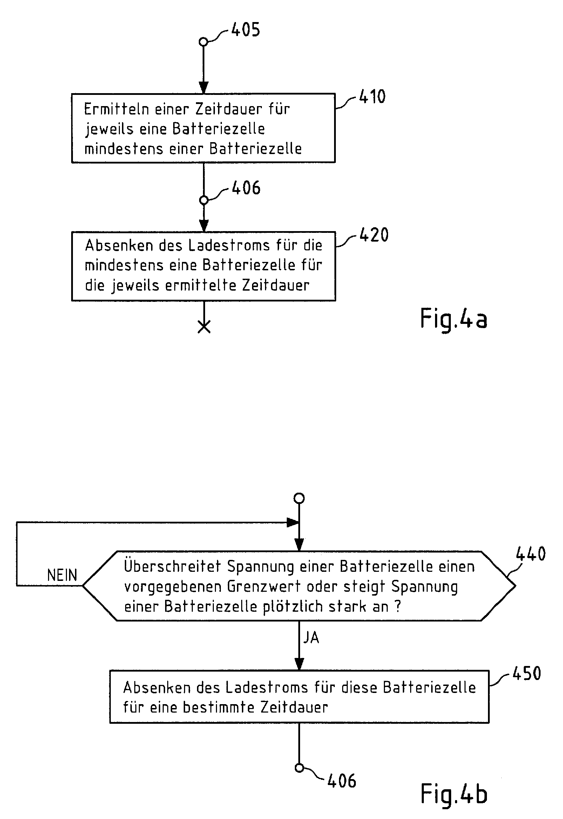

Fig. 4a zeigt eine schematische Darstellung eines Flussdiagramms einer siebten beispielhaften Ausstellungsform eines Verfahrens, die exemplarisch ein beispielhaftes Absenken des Ladestroms für mindestens eine Batteriezelle 160 auf Grundlage der ermittelten Batteriezustandsinformationen darstellt.

Die für das Absenken des Ladestroms verwendeten Batteriezustandsinformationen können beispielsweise die Reihenfolge, in welcher die Batteriezellen 160 während eines Ladevorgangs jeweils eine vordefinierte Spannung erreichen, umfassen. Die Steuervorrichtung 140 kann dazu eingerichtet sein, während eines Ladevorgangs die einzelnen Spannungen der Batteriezellen 160 zu überwachen und abzuspeichern, in welcher Reihenfolge die jeweiligen Batteriezellen die vordefinierte Spannung erreichen. Diese Reihenfolge stellt beispielsweise eine Information über die Gesundheit der jeweiligen Batteriezellen 160 dar, da eine schlechtere Batteriezelle 160 während eines Ladevorgangs die vordefinierte Spannung eher erreicht als eine bessere Batteriezelle 160.

Die für das Absenken des Ladestroms verwendeten Batteriezustandsinformationen können ferner beispielsweise eine Zeitinformation über den Zeitpunkt, zu welchem eine jeweilige Batteriezelle 160 während eines Ladevorgangs jeweils die vordefinierte Spannung erreicht hat, umfassen.

Die Steuervorrichtung 140 kann dementsprechend dazu eingerichtet sein, diese Zeitinformation über den Zeitpunkt, zu welchem eine jeweilige Batteriezelle 160 während eines Ladevorgangs jeweils die vordefinierte Spannung erreicht hat, zu ermitteln. Diese Zeitinformation stellt beispielsweise ebenfalls eine Information für die Gesundheit der jeweiligen Batteriezellen 160 dar: Eine Batteriezelle 160, welche die vordefinierte Spannung besonders schnell erreicht hat, stellt eine schlechte Batteriezelle 160 dar, während eine Batteriezelle 169, welche die vordefinierte Spannung erst zu einem späten Zeitpunkt erreicht hat, stellt eine bessere Batteriezelle 160 dar.

Das in Fig. 4a dargestellte beispielhafte siebte Verfahren umfasst das Ermitteln einer Zeitdauer für jeweils eine Batteriezelle 160 mindestens eine Batteriezelle 160 der Vielzahl von Batteriezellen 160, für die der Ladestrom der jeweiligen Batteriezelle abzusenken ist, auf Grundlage der gespeicherten Batterieinformationen.

Beispielsweise können diese gespeicherten Batterieinformationen eine Information über die Gesundheit der jeweiligen Batteriezellen 160 umfassen, wie beispielsweise die erläuterte Information über die Reihenfolge, in welcher die Batteriezellen 160 während eines Ladevorgangs jeweils eine vordefinierte Spannung erreichen, und/oder die Zeitinformation über den Zeitpunkt, zu welchen eine jeweilige Batteriezelle 160 während eines Ladevorgangs jeweils die vordefinierte Spannung erreicht hat, oder eine andere geeignete Information über den Gesundheitszustand der jeweiligen Batteriezellen 160. Die Steuervorrichtung 140 kann beispielsweise dazu eingerichtet sein, für eine Batteriezelle 160 mit einem schlechteren Gesundheitszustand einen längeren Zeitraum zur Absenkung des Ladestroms zu ermitteln, als für eine Batteriezelle 160 mit einem besseren Gesundheitszustand, wobei der jeweilige Gesundheitszustand aus der entsprechenden Information über den Gesundheitszustand der jeweiligen Batteriezelle 160 ermittelt werden. Beispielsweise kann der Batteriezelle mit dem besten Gesundheitszustand der Zeitraum "0" zugeordnet werden, d.h. der Strom für diese Batteriezelle soll während des Ladevorgangs überhaupt nicht abgesenkt werden, während mindestens einer der anderen Batteriezellen 160 der Vielzahl von Batteriezellen jeweils in Abhängigkeit des jeweiligen Gesundheitszustandes ein Zeitraum zugeordnet wird, der mit schlechterem Gesundheitszustand der jeweiligen Batteriezelle länger ausfällt.

Somit kann während des in Fig. 4b in Schritt 420 dargestellten Ladevorgangs der Ladestrom für die schlechteren Batteriezellen 160 für einen längeren Zeitraum abgeschaltet werden, während der Ladestrom für die besseren Batteriezellen 160 nur für einen kürzeren Zeitraum oder überhaupt nicht abgeschaltet wird. Somit kann ein Ausgleichen der Batteriezellen 160 während dieses Ladevorgangs erzielt werden.

Fig. 4b zeigt eine schematische Darstellung eines Flussdiagramms einer achten beispielhaften Ausstellungsform eines Verfahrens.

In Schritt 440 wird von der Steuervorrichtung 140 während eines Ladevorgangs überwacht, ob die Spannung einer Batteriezelle 160 einen vorgegebenen Grenzwert überschreitet oder ob die Spannung einer Batteriezelle 160 plötzlich stark ansteigt. Wird dies für eine Batteriezelle 160 festgestellt, so wird danach der Ladestrom für diese Batteriezelle für eine Zeitdauer reduziert, wie in Schritt 450 angedeutet. Diese Zeitdauer kann beispielsweise analog zur zuvor in Bezug auf Fig. 4a erläuterten ermittelten Zeitdauer ermittelt werden, wobei diese Zeitdauer beispielsweise erst nach Detektion des Überschreiten der Spannung und/oder des plötzlichen Spannungsanstiegs in Schritt 440 ermittelt wird. Darüberhinaus kann die Information über den Gesundheitszustand auch Information über den jeweiligen Ladezustand der anderen Batteriezellen 160 umfassen.

Somit können aktuelle Informationen über den Gesundheitszustand von weiteren Batteriezellen 160 zur Ermittlung dieser Zeitdauer berücksichtigt werden. Der Ladestrom für diese Batteriezelle 160 muss nicht zwingend unmittelbar nach positiver Detektion in Schritt 440 abgeschaltet werden, sondern der Ladestrom kann beispielsweise während des weiteren Ladevorgangs ab einem beliebigen Zeitpunkt für den ermittelten Zeitraum abgesenkt werden.

Im einfachsten Fall kann jedoch die Zeitdauer einfach auf eine Zeitdauer bis zum Ende des Ladevorgangs gesetzt werden, so dass für diese Batteriezelle 160 eine Absenkung des Ladestroms direkt nach positiver Detektion in Schritt 440 bis zum Ende des gesamten Ladevorgangs erfolgen kann.

Das in Fig. 4b gezeigte Verfahren kann für mindestens eine Batteriezelle 160 der Vielzahl von Batteriezellen 160 während eines Ladevorgangs durchgeführt werden, es kann beispielsweise für sämtliche Batteriezellen 160 der Vielzahl von Batteriezellen 160 durchgeführt werden.

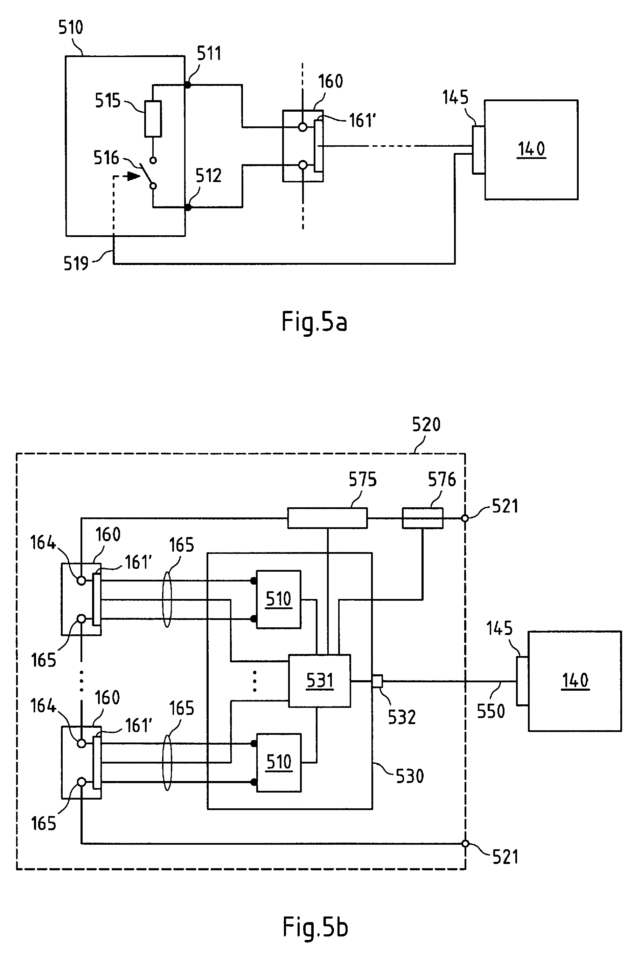

Dieses Absenken des Ladestroms gemäß Schritt 410 in Fig. 4a oder Schritt 440 kann beispielsweise durch entsprechende Ansteuerung eines ansteuerbaren Ladegeräts, wie zuvor beschrieben erfolgen, und oder durch Ansteuerung mindestens eines schaltbaren Ausgleichselements, wobei jedes des mindestens einen schaltbaren Ausgleichselements 510 einer Batteriezelle 160 zugeordnet ist, wie beispielhaft in Fig. 5a dargestellt.

Beispielsweise kann der in Schritt 440 verwendete vorgegebene Grenzwert der Ladeendspannung, d.h. der maximalen Ladespannung der Batteriezelle 160 entsprechen, allerdings kann dieser vorgegebene Grenzwert auch ein Spannungswert sein, der unterhalb der maximalen Ladespannung der Batteriezelle 160 liegt. Dies kann insbesondere dann vorteilhaft sein, wenn kein ansteuerbares Ladegerät verwendet wird.

In Fig. 5a ist beispielhaft die Anordnung eines schaltbaren Ausgleichselements 510 für eine Batteriezelle 160 in einem beispielhaften System dargestellt. Das schaltbare Ausgleichselement 510 ist dazu eingereichtet, einen Bypasspfad parallel zu der jeweiligen Batteriezelle 160 ein- bzw. auszuschalten, wobei dieser Bypasspfad mindestens einen Widerstand 515 umfassen kann, und wobei das schaltbare Ausgleichselement einen Schalter 516 zum Ein- bzw. Ausschalten dieses Bypasspfades umfasst. Dieser Schalter 516 kann beispielsweise mindestens einen Transistor umfassen.

Beispielsweise kann hierfür ein Fet-Transistor verwendet werden, wie beispielsweise ein MOSFet oder dergleichen.

Die Steuervorrichtung 140 ist dazu eingerichtet, dass jeweilige schaltbare Ausgleichselement 510 anzusteuern, d.h. den Schalter 516 des Bypasspfades ein- bzw. auszuschalten, sodass beim Einschalten des Schalters 516 der Bypasspfad geschlossen wird und ein durch die Batteriezelle 160 fließender Ladestrom zumindest teilweise durch das schaltbare Ausgleichselement 516 fließt, wodurch der Ladestrom für die jeweilige Batteriezelle 116 abgesenkt werden kann. Beispielsweise kann der Bypasspfad eines schaltbaren Ausgleichselements 510 auch derart ausgestaltet sein, dass nahezu der komplette Ladestrom an der jeweiligen Batteriezelle 160 durch das jeweilige schaltbare Ausgleichselement 510 vorbeigeführt wird.

Darüber hinaus kann das schaltbare Ausgleichselement 510 auch mit mindestens einer weiteren Batteriezelle 160 verbunden sein, wobei der durch den Bypasspfad des schaltbaren Ausgleichselements 510 fließende Strom als zusätzlicher Ladestrom für diese mindestens eine weitere Batteriezelle 160 verwendet wird. Somit kann ein aktives Ausgleichen zwischen der in Fig. 5a dargestellten beispielhaften einen Batteriezelle 160 und mindestens einer weiteren Batteriezelle 160 durchgeführt werden, wobei der für die in Fig. 5a dargestellte Batteriezelle 160 vorgesehener Ladestrom durch das schaltbare Ausgleichselement 510 bei einschalten des Schalters 516 zu der mindestens einen weiteren Batteriezelle 160 (nicht in Fig. 5a dargestellt) hingeführt wird. Für dieses aktive Ausweichen kann der mindestens eine Widerstand 515 im Bypasspfad beispielsweise entfallen.

Der im beispielhaft dargestellten schaltbaren Ausgleichselement 510 ausgebildete eine Bypasspfad kann auch beispielsweise durch eine Parallelschaltung von mehreren Bypassfäden realisiert werden, wobei jeder dieser mehreren parallelen Bypasspfade jeweils mindestens einen Widerstand umfasst. Beispielsweise kann ein zentraler Schalter die mehreren parallelen Bypasspfade ein- und ausschalten, es kann jedoch auch in jeweils mindestens einem Bypasspfad ein Schalter vorgesehen sein, so dass beispielsweise einzelne Bypasspfade der mehreren Bypasspfade eingeschaltet werden können. Somit kann beispielsweise eine Überlastung eines einzigen Bypasspfades vermieden werden.

Die jeweiligen schaltbaren Ausgleichselemente 510 können in der Nähe der Batteriezellen 160 angeordnet sein, sie können aber auch an oder in der Steuervorrichtung 140 angeordnet sein. Darüber hinaus kann mindestens eines der schaltbaren Ausgleichselemente 510 mit einem Kühlkörper versehen sein.

Fig. 5b zeigt eine schematische Darstellung einer vierten beispielhaften Ausführungsform eines Systems. Dieses vierte beispielhafte System kann beispielsweise auf dem in Fig. 1e dargestellten zweiten beispielhaften System basieren. So umfasst das vierte beispielhafte System in Fig. 5b einen Block 520 mit einer Mehrzahl von Batteriezellen 160, wobei das System auch weitere Blöcke 520 mit jeweils einer Mehrzahl von Batteriezellen umfassen kann. In Fig. 5b ist jedoch beispielhaft nur ein einziger dieser Blöcke 520 dargestellt. Diesem Block 520 ist ein Modul 530 zugeordnet, wobei dieses Modul eine Mehrzahl von schaltbaren Ausgleichselementen 510 umfasst, sodass jedes dieser schaltbaren Ausgleichselemente 510 jeweils einer der Batteriezellen 160 der Mehrzahl von Batteriezellen 160 des Blocks 520 zugeordnet ist. Ein schaltbares Ausgleichselement 510 ist hierzu mit der Schnittstelle 161' der jeweiligen Batteriezelle 160 verbunden, sodass die beiden Pole 164 und 165 dieser Batteriezelle mit dem schaltbaren Ausgleichselement 510 verbunden sind. Darüber hinaus kann das Modul 530 eine Kommunikationseinheit 531 umfassen, welche jeweils mit einzelnen Verbindungen 165 mit den jeweiligen Schnittstellen 161' zum Auslesen der jeweiligen Parameter der einzelnen Batteriezellen 160 verbunden sein kann. Beispielsweise kann diese Verbindung 165 durch ein Bussystem realisiert werden. Darüber hinaus ist die Kommunikationseinheit 531 auch dazu eingerichtet, den Parameter Batteriespannung einer jeweiligen Batteriezelle 160 zu erfassen, wobei hierzu beispielsweise die Spannung an dem jeweiligen schaltbaren Ausgleichselement 510 abgegriffen werden kann, d.h., die beiden Verbindungen zu den jeweiligen Batteriepolen 164 und 165 der jeweils dem schaltbaren Ausgleichselement 510 zugeordneten Batteriezelle 160 kann verbindbar zur Kommunikationseinheit 531 ausgestaltet sein. Beispielsweise kann die Kommunikationseinheit 531 einen Multiplexer umfassen, mit dem jeweils die Spannung einer der Batteriezellen 160 erfasst werden kann, sodass diese jeweils erfasste Spannung einer Batteriezelle 160 an die Steuervorrichtung 140 weiter gesendet werden kann. Beispielsweise kann die Kommunikationseinheit 531 jeweils nacheinander die Spannungen der einzelnen Batteriezellen 160 eines Blocks 520 auslesen und an die Steuervorrichtung 140 senden. Die Steuervorrichtung 140 kann aber auch dazu eingerichtet werden, die Kommunikationseinheit 531 derart anzusteuern, dass eine von der Steuervorrichtung 140 gewünschte Spannung einer bestimmten Batteriezelle 160 ausgelesen und zurück an die Steuervorrichtung 140 übertragen wird. Das Modul 530 umfasst eine Schnittstelle 532, die mit der Kommunikationseinheit 531 verbunden ist, und dazu eingerichtet ist, über eine Verbindung 550 mit der Schnittstelle 145 der Steuervorrichtung 140 zu kommunizieren. Die Kommunikationseinheit 531 ist darüber hinaus mit einem Stromsensor 575 verbunden, welcher dem in Fig. 1e dargestellten Stromsensor 175 entsprechen kann. Darüber hinaus kann die Kommunikationseinheit 531 mit einem Schaltelement 576 verbunden sein, wobei dieses Schaltelementen 576 dazu eingerichtet ist, die Batteriezellen 160 des Bocks 520 von einer Ausgangsklemme 521 des Blocks 520 zu trennen bzw. zu verbinden. Somit kann beispielsweise bei einer der zuvor beschriebenen Überspannungsdetektion bei einer der Batteriezellen 160 des Blocks 520 dieser Bock 520 durch Trennen des Schaltelements 576 abgeschaltet werden. Die Batteriezellen 160 in diesem Bock 520 können wie zuvor im Bezug auf den in Fig. 1e dargestellten Block 180 beispielsweise in Reihe geschaltet werden, oder auch parallel geschaltet werden oder auch in einer Kombination aus einer Reihen- bzw. Parallelschaltung geschaltet werden. Die zuvor getroffenen Erläuterungen in Bezug auf einen Block 180 können, soweit technisch sinnvoll, auch auf diesen Block 520 in Fig. 5b übertragen werden.

## Patentansprüche

1. Verfahren, umfassend:

   - Erfassen mindestens eines Parameters für mindestens eine Batteriezelle einer Vielzahl von Batteriezellen während eines Lade- oder Entladevorgangs, wobei die Vielzahl von Batteriezellen zur Versorgung eines Elektrofahrzeuges eingerichtet sind und der mindestens eine Parameter mindestens einen der Parameter Spannung, Strom und Temperatur umfasst;
   - Ermitteln von Batteriezustandsinformationen für mindestens eine Batteriezelle der Vielzahl von Batteriezellen auf Grundlage des erfassten mindestens einen Parameters; und
   - Speichern der Batteriezustandsinformationen.

2. Verfahren nach Anspruch 1, wobei die ermittelten Batteriezustandsinformationen mindestens eine der folgenden Informationen umfassen:

   - die Reihenfolge, in welcher die Batteriezellen während eines Ladevorgangs jeweils eine vordefinierte Spannung erreichen;
   - Zeitinformationen über den Zeitpunkt, zu welchem die jeweilige Batteriezelle eine vordefinierte Spannung während eines Ladevorgangs erreicht;
   - Information über den Ladezustand der jeweiligen Batteriezelle;
   - Information über einen kritischen Zustand einer jeweiligen Batteriezelle; und
   - Information über die Anzahl der Lade- und/oder Entladezyklen der jeweiligen Batteriezelle.

3. Verfahren nach Anspruch 2, wobei die Information über den Ladezustand der jeweiligen Batteriezelle mindestens einen der folgenden Werte umfasst:

   - absoluter Ladezustand;
   - normierter Ladezustand;
   - einen auf einen eingeschränkten Kapazitätsbereich abgebildeten Ladezustand.

4. Verfahren nach einem der Ansprüche 2 oder 3, wobei die Information über die Anzahl der Lade- und/oder Entladezyklen der jeweiligen Batteriezelle einen Wert über einen aktuellen Teilladezyklus umfasst, welcher ein Maß für die der jeweiligen Batteriezelle zugeführten bzw. entnommenen Ladung während eines Lade- bzw. eines Entladevorgangs darstellt.

5. Verfahren nach Anspruch 4, wobei die Information über die Anzahl der Lade- und/oder Entladezyklen der jeweiligen Batteriezelle einen Wert für einen Ladezyklus und einen Wert für einen Endladezyklus umfasst, und das Verfahren das Ermitteln des Werts über den aktuellen Teilladezyklus während eines Lade- oder eines Entladevorgangs mfasst; und das Verfahren nach dem Ende des Lade- oder Entladevorgangs folgendes umfasst:

   - Aufaddieren eines auf dem Wert über einen aktuellen Teilladeyklus basierenden Werts auf den Wert für einen Ladezyklus, wenn ein Ladevorgang beendet wurde;
   - Aufaddieren eines auf dem Wert über einen aktuellen Teilladezyklus basierenden Werts auf den Wert für einen Endladezyklus, wenn ein Entladezyklus beendet wurde; und
   - Zurücksetzen des Werts für einen aktuellen Teilladezyklus.

6. Verfahren nach Anspruch 5, wobei die Information über die Anzahl der Lade- und/oder Entladezyklen der jeweiligen Batteriezelle jeweils einen Wert für die Anzahl der Lade- bzw. Entladezyklen umfasst, und das Verfahren umfasst:

   - Vergleichen, ob der Wert für einen Lade- oder Endladezyklus einen Referenzwert erreicht oder überschreitet; und
   Inkrementieren des entsprechenden Werts für die Anzahl der Lade- bzw. Entladezyklen und Zurücksetzen des entsprechenden Werts für einen Lade- oder Endladezyklus, wenn der Referenzwert erreicht oder überschritten wurde.

7. Verfahren nach einem der vorangegangenen Ansprüche, umfassend das Steuern bzw. Regeln eines Ladevorgangs und/oder Entladevorgangs mindestens einer Batteriezelle der Vielzahl von Batteriezellen auf Grundlage der ermittelten Batteriezustandsinformationen und/oder auf Grundlage des mindestens einen erfassten Parameters.

8. Verfahren nach einem der vorangegangenen Ansprüche, umfassend das Absenken eines Ladestroms für mindestens eine Batteriezelle der Vielzahl von Batteriezellen während eines weiteren Ladevorgangs auf Grundlage der gespeicherten Batteriezustandsinformationen.

9. Verfahren nach Anspruch 8, umfassend:

   - Ermitteln einer Zeitdauer für jeweils eine Batteriezelle der mindestens einen Batteriezelle, für die der Ladestrom der jeweiligen Batteriezelle abzusenken ist, auf Grundlage der gespeicherten Batteriezustandsinformationen; und

- Absenken des Ladestroms für jede der mindestens einen Batteriezelle für die jeweils ermittelte Zeitdauer.

10. Verfahren nach einem der Ansprüche 8 bis 9, umfassend:

- Prüfen, ob die Spannung einer Batteriezelle der Vielzahl von Batteriezellen einen vorgegebenen Grenzwert überschreitet oder ob diese Spannung plötzlich ansteigt;
- Absenken des Ladestroms für diese Batteriezelle für die ermittelte Zeitdauer, wenn die Spannung der Batteriezelle den vorgegeben Grenzwert überschritten hat oder wenn die Spannung plötzlich angestiegen ist.

11. Verfahren nach einem der Ansprüche 8 bis 10, wobei mindestens einer Batteriezelle der mindestens einen Batteriezelle jeweils ein schaltbares Ausgleichselement zugeordnet ist, welches dazu eingerichtet ist, einen Bypasspfad parallel zu der jeweiligen Batteriezelle ein- bzw. auszuschalten, und wobei das Absenken des Ladestroms für mindestens eine Batteriezelle der Vielzahl von Batteriezellen umfasst:

- Einschalten des jeweiligen Bypasspfads von mindestens einem schaltbaren Ausgleichselement.

12. Verfahren nach einem der Ansprüche 8 bis 11, wobei das Absenken eines Ladestroms für mindestens eine Batteriezelle der Vielzahl von Batteriezellen umfasst:

- Ansteuern eines Ladegeräts, welches mindestens einer Batteriezelle der mindestens einen Batteriezelle zugeordnet ist, zum Absenken des von dem Ladegerät für die mindestens eine Batteriezelle der mindestens einen Batteriezelle bereitgestellten Ladestroms.

13. Verfahren nach einem der vorangegangenen Ansprüche, umfassend das Durchführen einer Referenzladung mindestens einer Batteriezelle der Vielzahl von Batteriezellen.

14. Vorrichtung, I umfassend:

- Mittel zum Erfassen mindestens eines Parameters für mindestens eine Batteriezelle einer Vielzahl von Batteriezellen während eines Lade- oder Entladevorgangs, wobei die Vielzahl von Batteriezellen zur Versorgung eines Elektrofahrzeuges eingerichtet sind und der mindestens eine Parameter mindestens einen der Parameter Spannung, Strom und Temperatur umfasst;

- Mittel zum Ermitteln von Batteriezustandsinformationen für mindestens eine Batteriezelle der Vielzahl von Batteriezellen auf Grundlage des erfassten mindestens einen Parameters; und
- Mittel zum Speichern der Batteriezustandsinformationen.

15. System, umfassend eine Vorrichtung nach Anspruch 14 und eine Vielzahl von Batteriezellen, welche mit den Mitteln zum Erfassen der Vorrichtung derart verbunden sind, dass die Vorrichtung den mindestens eines Parameters für mindestens eine Batteriezelle der Vielzahl von Batteriezellen während eines Lade- oder Entladevorgangs erfassen kann.

Erfassen mindestens eines Parameters
mindestens einer Batteriezelle einer
Vielzahl von Batteriezellen ⌐110

Ermitteln von Batteriezustandsinformationen
für mindestens eine Batterie auf Grundlage
des erfassten mindestens einen Parameters ⌐120

Speichern der Batteriezustandsinformationen ⌐130

Fig.1a

140

Steuervorrichtung

145⌐

Fig.1b

Fig.1c

Fig.1d

Fig.1e

Liegt kritischer Zustand mindestens einer Batteriezelle vor ?

Trennen des Leistungsschalters

Vordefinierter Zeitraum abgelaufen ?

Schließen des Leistungsschalters

Fig.2a

205

NEIN — Liegt Spannung einer Batteriezelle außerhalb eines vordefinierten Spannungsbereichs ? — 211

JA — 215

**Fig.2b**

205

NEIN — Liegt Spannung einer Batteriezelle außerhalb eines zweiten vordefinierten Spannungsbereichs ? — 212

JA

NEIN — Ist weiteres Abbruchkriterium erfüllt ? — 213

JA — 215

**Fig.2c**

Fig.3a

Fig.3b

Fig.4a

Fig.4b

Fig.5a

Fig.5b

**Europäisches Patentamt**
**European Patent Office**
**Office européen des brevets**

## EUROPÄISCHER RECHERCHENBERICHT

**Nummer der Anmeldung**

EP 10 18 6547

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2001/022518 A1 (ASAKURA KAORU [JP] ET AL) 20. September 2001 (2001-09-20) | 1,14 | INV.<br>G01R31/36<br>H02J7/00<br>B60L11/18 |
| Y | * Absatz [0077] - Absatz [0136]; Abbildungen 1-3 *<br>* Absatz [0687] - Absatz [0722]; Abbildungen 43,44 * | 2 | |
| | ----- | | |
| X | GB 2 461 350 A (HITACHI LTD [JP]) 6. Januar 2010 (2010-01-06)<br>* Seite 6 - Seite 23; Abbildungen 1-11 * | 1 | |
| | ----- | | |
| X | EP 2 110 679 A1 (PANASONIC EV ENERGY CO LTD [JP]) 21. Oktober 2009 (2009-10-21)<br>* Absatz [0015] - Absatz [0026]; Abbildungen 1,2 * | 1 | |
| | ----- | | |
| X | DE 10 2007 036064 A1 (SZEPAN REINER [DE]) 5. Februar 2009 (2009-02-05) | 1 | |
| Y | * Absatz [0011] - Absatz [0012] *<br>----- | 2 | |

| | RECHERCHIERTE SACHGEBIETE (IPC) |
|---|---|
| | G01R<br>H02J<br>B60L |

Der vorliegende Recherchenbericht wurde für alle Patentansprüche erstellt

| Recherchenort | Abschlußdatum der Recherche | Prüfer |
|---|---|---|
| München | 29. März 2011 | Hijazi, Ali |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.......................................................................
& : Mitglied der gleichen Patentfamilie, übereinstimmendes Dokument

EPO FORM 1503 03.82 (P04C03)

Europäisches
Patentamt

European
Patent Office

Office européen
des brevets

## GEBÜHRENPFLICHTIGE PATENTANSPRÜCHE

Die vorliegende europäische Patentanmeldung enthielt bei ihrer Einreichung Patentansprüche, für die eine Zahlung fällig war.

☐ Nur ein Teil der Anspruchsgebühren wurde innerhalb der vorgeschriebenen Frist entrichtet. Der vorliegende europäische Recherchenbericht wurde für jene Patentansprüche erstellt, für die keine Zahlung fällig war, sowie für die Patentansprüche, für die Anspruchsgebühren entrichtet wurden, nämlich Patentansprüche:

☐ Keine der Anspruchsgebühren wurde innerhalb der vorgeschriebenen Frist entrichtet. Der vorliegende europäische Recherchenbericht wurde für die Patentansprüche erstellt, für die keine Zahlung fällig war.

## MANGELNDE EINHEITLICHKEIT DER ERFINDUNG

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

```
Siehe Ergänzungsblatt B
```

☐ Alle weiteren Recherchengebühren wurden innerhalb der gesetzten Frist entrichtet. Der vorliegende europäische Recherchenbericht wurde für alle Patentansprüche erstellt.

☐ Da für alle recherchierbaren Ansprüche die Recherche ohne einen Arbeitsaufwand durchgeführt werden konnte, der eine zusätzliche Recherchengebühr gerechtfertigt hätte, hat die Recherchenabteilung nicht zur Zahlung einer solchen Gebühr aufgefordert.

☐ Nur ein Teil der weiteren Recherchengebühren wurde innerhalb der gesetzten Frist entrichtet. Der vorliegende europäische Recherchenbericht wurde für die Teile der Anmeldung erstellt, die sich auf Erfindungen beziehen, für die Recherchengebühren entrichtet worden sind, nämlich Patentansprüche:

☒ Keine der weiteren Recherchengebühren wurde innerhalb der gesetzten Frist entrichtet. Der vorliegende europäische Recherchenbericht wurde für die Teile der Anmeldung erstellt, die sich auf die zuerst in den Patentansprüchen erwähnte Erfindung beziehen, nämlich Patentansprüche:

```
1, 14(vollständig); 2(teilweise)
```

☐ Der vorliegende ergänzende europäische Recherchenbericht wurde für die Teile der Anmeldung erstellt, die sich auf die zuerst in den Patentansprüchen erwähnte Erfindung beziehen (Regel 164 (1) EPÜ).

| Europäisches Patentamt<br>European Patent Office<br>Office européen des brevets | **MANGELNDE EINHEITLICHKEIT<br>DER ERFINDUNG<br>ERGÄNZUNGSBLATT B** | **Nummer der Anmeldung**<br>EP 10 18 6547 |
| --- | --- | --- |

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

1. Ansprüche: 1, 14(vollständig); 2(teilweise)

   Verfahren zur Ermittlung von Batteriezustandsinformationen wobei die Batteriezustandsinformationen die Reihenfolge umfassen, in welcher die Batteriezellen während eines Ladevorgangs jeweils eine vordefinierte Spannung erreichen oder Zeitinformationen über den Zeitpunkt, zu welchem die jeweilige Batteriezelle eine vordefinierte Spannung während eines Ladevorgangs erreicht
   ---

2. Ansprüche: 1(vollständig); 2, 3(teilweise)

   Verfahren zur Ermittlung von Batteriezustandsinformationen wobei die Batteriezustandsinformationen Information über den absolute Ladezustand der jeweiligen Batteriezelle umfassen
   ---

3. Ansprüche: 1(vollständig); 2, 3(teilweise)

   Verfahren zur Ermittlung von Batteriezustandsinformationen wobei die Batteriezustandsinformationen Information über den normierte Ladezustand der jeweiligen Batteriezelle umfassen
   ---

4. Ansprüche: 1(vollständig); 2, 3(teilweise)

   Verfahren zur Ermittlung von Batteriezustandsinformationen wobei die Batteriezustandsinformationen Information über einen auf einen eingeschränkten Kapazitätsbereich abgebildeten Ladezustand der jeweiligen Batteriezelle umfassen
   ---

5. Ansprüche: 1(vollständig); 2(teilweise)

   Verfahren zur Ermittlung von Batteriezustandsinformationen wobei die Batteriezustandsinformationen Information über einen kritischen Zustand einer jeweiligen Batteriezelle umfassen
   ---

6. Ansprüche: 1, 4-6(vollständig); 2(teilweise)

   Verfahren zur Ermittlung von Batteriezustandsinformationen wobei die Batteriezustandsinformationen Information über die Anzahl der Lade- und/oder Entladezyklen der jeweiligen Batteriezelle umfassen
   ---

7. Ansprüche: 1, 7

Europäisches
Patentamt

European
Patent Office

Office européen
des brevets

**MANGELNDE EINHEITLICHKEIT
DER ERFINDUNG
ERGÄNZUNGSBLATT B**

**Nummer der Anmeldung**

EP 10 18 6547

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

Verfahren, das das Steuern bzw. Regeln eines Ladevorgangs und/oder Entladevorgangs mindestens einer Batteriezelle einer Vielzahl von Batteriezellen auf Grundlage der ermittelten Batteriezustandsinformationen und/oder auf Grundlage eines erfassten Parameters umfasst

---

8. Ansprüche: 1, 8-12

Verfahren, das das Absenken eines Ladestroms für mindestens eine Batteriezelle einer Vielzahl von Batteriezellen während eines weiteren Ladevorgangs auf Grundlage der gespeicherten Batteriezustandsinformationen umfasst

---

9. Ansprüche: 1, 13

erfahren, das das Durchführen einer Referenzladung mindestens einer Batteriezelle der Vielzahl von Batteriezellen umfasst

---

10. Ansprüche: 14, 15

System, das eine Vorrichtung zur Ermittlung von Batteriezustandsinformationen mit mitteln zum Erfassen eines Parameters und eine Vielzahl von Batteriezellen umfasst, welche mit den Mitteln zum Erfassen der Vorrichtung derart verbunden sind, dass die Vorrichtung mindestens eines Parameters für mindestens eine Batteriezelle der Vielzahl von Batteriezellen während eines Lade- oder Entladevorgangs erfassen kann

---

**ANHANG ZUM EUROPÄISCHEN RECHERCHENBERICHT
ÜBER DIE EUROPÄISCHE PATENTANMELDUNG NR.**

EP 10 18 6547

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

29-03-2011

| Im Recherchenbericht angeführtes Patentdokument | Datum der Veröffentlichung | Mitglied(er) der Patentfamilie | Datum der Veröffentlichung |
|---|---|---|---|
| US 2001022518 A1 | 20-09-2001 | KR 20010091990 A<br>KR 20030051457 A<br>KR 20030051458 A<br>TW 510977 B | 23-10-2001<br>25-06-2003<br>25-06-2003<br>21-11-2002 |
| GB 2461350 A | 06-01-2010 | KEINE | |
| EP 2110679 A1 | 21-10-2009 | JP 2008288192 A<br>WO 2008096771 A1<br>US 2010004885 A1 | 27-11-2008<br>14-08-2008<br>07-01-2010 |
| DE 102007036064 A1 | 05-02-2009 | KEINE | |

EPO FORM P0461

Für nähere Einzelheiten zu diesem Anhang : siehe Amtsblatt des Europäischen Patentamts, Nr.12/82